# EUROPEAN PATENT SPECIFICATION

(11) **EP 2 517 275 B1**
(45) Date of publication and mention of the grant of the patent: **07.11.2018**
(21) Application number: 10790615.8
(22) Date of filing: 24.11.2010
(51) Int. Cl.: H01L 51/00, H01L 51/54

(54) **FORMULATIONS COMPRISING PHASE-SEPARATED FUNCTIONAL MATERIALS**
FORMULIERUNGEN MIT PHASENGETRENNTEN FUNKTIONSMATERIALIEN
FORMULATIONS COMPRENANT DES MATÉRIAUX FONCTIONNELS À PHASES SÉPARÉES

(30) Priority: 22.12.2009 EP 09015860
(43) Date of publication of application: 31.10.2012
(73) Proprietor: Merck Patent GmbH, 64293 Darmstadt (DE)
(72) Inventor: PAN, Junyou, 60320 Frankfurt am Main (DE); EBERLE, Thomas, 76829 Landau (DE)
(86) International application number: PCT/EP2010/007116
(87) International publication number: WO 2011/076323

(56) References cited:
- WO-A1-01/86734
- WO-A1-96/16449
- WO-A1-02/084758
- WO-A1-03/050147
- JP-A- 2003 249 373
- US-A1- 2003 227 014
- US-A1- 2009 256 117

## Description

The present invention relates, inter alia, to formulations, to methods for their preparation, and the use of said formulations for the preparation of electronic or opto-electronic devices.

Organic electronics, such as organic light-emitting diodes (OLEDs), organic field-effect transistors (OFETs), organic photovoltaic cells (OPVs), organic light-emitting electro-chemical cells (OLECs) have drawn much attention in the past two decades, because they are versatile in material design, light-weight, and suitable for large area application. These organic electronic devices usually comprise a multilayer structure. Hereby it is crucial to deposit the active organic materials on the nano- to mesoscopic scale on a substrate. In addition, the formation of organic multilayer structures has to occur without affecting the underlying layers in an uncontrolled way. The development of cost effective technologies for the mass production of organic electronics will have a decisive role for their competitiveness as compared to current technologies employed. Cost reduction for the mass production is therefore a mandatory prerequisite for the commercial success of organic electronics. In order to achieve this goal solution based deposition methods could provide a solution. However, current technologies do not offer a competitive way to adequately prepare multilayered structures for organic electronics, particularly if they comprise small molecules. This is due to the fact that layers that have already been deposited may be, at least in part, dissolved or washed away when another layer is deposited on it.

In the case of OLEDs, the formation of patterned light emitting layers is an important but difficult step in the production of electroluminescent devices. For example, the formation of separate red, green and blue patterned emitter layers is typically required in the production of electroluminescent full color display devices. Vacuum evaporation (e.g., using a shadow mask) is the most common technique to form each of the patterned layers. However, vacuum evaporation techniques have a couple of drawbacks which may significantly inhibit the commercial development of multilayer structures comprising organic materials such as OLEDs. These techniques are rather complex in terms of equipment needed. In particular for large format displays, other methods for manufacturing patterned layers are needed. Methods based on depositing materials from solution are especially desirable for their expected compatibility with large scale device fabrication.

The possible technologies are, for example, ink-jet printing, dip coating, spin coating, letter-press printing, screen printing, doctor blade coating, and slot-die coating etc. Ink-jet printing is particularly preferred as it allows high resolution displays to be prepared. However, all of these technologies suffer from their applicability to a broad spectrum of organic semiconductors and it is, therefore, highly desirable to find other ways to build a multilayer structure. There are two approaches to do this. The first one is to use a cross-linkable compound, as disclosed in EP 0637899 A1; here one first immobilises the first layer by cross linking induced either thermally or by exposure to (UV) light, before the next layer is coated or printed on that. The disadvantage of this approach is one has to introduce the cross-linkable compound in the layer, or even design the cross-linkable functional group in organic functional compounds; and moreover the residual cross-linkable group could also be harmful to the device performance. The second approach is to use so-called orthogonal solvents, e.g, the first layer is insoluble in the solvent of the solution, from which the second layer will be coated. To do so, one has to either have a pair of compounds, which are soluble in orthogonal solvents, or to find a suitable formulation, which fulfils the condition of orthogonal solvents.

One approach is disclosed in WO 2003/050147 A1 to prepare conjugated polymer dispersion from mini-emulsions, where the conjugated polymers are in form of small spherical units called semiconducting polymer nano-spheres (SPNs). Miniemulsions are understood to be stable emulsions of droplets with a distinct size between 1 and 7000 nm, made by shearing a system containing a solvent A, a solution (in a solvent B) of a compound insoluble in solvent A, and a small amount of a surfactant, whereby solvent A is immiscible with solvent B. Polymer particles can be obtained from such droplets after evaporation of solvent A. The formulation of conjugated polymer in dispersion disclosed in WO 2003/050147 A1can be used to build multilayer structures in, e.g. OLEDs and OPVs. The deposition of polymer is known in the prior art WO03/050147 A1 discloses an emulsion comprising a continuous phase comprising water and a discontinuous phase comprising a polymer.

However, the performance of OLEDs based on small molecules (SMOLEDs) is in most cases much better as compared to OLEDs based on conjugated polymers (PLEDs). PLEDs suffer, for instance, from insufficient lifetime. On the other hand, recently the SMOLEDs have shown excellent performance, in aspects of color, lifetime and driving voltages. Actually, SMOLEDs has already achieved commercial entry into small display market, like mobile phone. In order to overcome the disadvantages of the thermal vacuum deposition which leads to a low material exploitation and to limited device dimension, the present invention relates to a method to formulate particularly small molecular compounds in miniemulsions and dispersions for facilitating the formation of a multilayer structure.

Document JP2003249373 A discloses a formulation comprising at least one continuous phase comprising thiourea complex of zinc and at least one discontinuous phase comprising CdSe particles. Said formulation is used as the electroluminescent layer in an electroluminescence device.

It is therefore highly desired to find a way to formulate and coat the small molecule based materials on large area, in order to take advantage of their favorable electronic and opto-electronic characteristics without modifying the chemical structure of these compounds.

It is an object of the present invention to overcome the problems known in the prior art. In particular, it is an object of the present invention to provide emulsions and dispersions, methods for their preparations and their use for the preparation of electronic and opto-electronic devices with multilayer structure.

Surprisingly, it has been found that emulsions and dispersions comprising functional materials can be formed. These emulsions and dispersions, commonly referred herein to as formulations, can be employed in order to prepare devices with layer and multilayer structures by using simple deposition techniques from solution. The formulations according to the present invention are particularly important and useful for the preparation of opto-electronic devices such as OLEDs, solar cells, and photovoltaic cells.

The general distinction between emulsion and dispersion is up to the composition of one or more of the discontinuous phases. An emulsion comprises, in addition to the functional materials, which are defined below, at least one solvent. If the solvent is removed a dispersion is obtained. The discontinuous phase of the formulation can exist in the form of a nanodroplet and nanoparticle in the case of an emulsion and dispersion, respectively.

The present invention relates to a formulation comprising at least one continuous phase and at least one discontinuous phase, characterized in that at least one of the continuous phases comprises at least one first functional material and wherein at least one of the discontinuous phases comprises at least one second functional material and wherein the first and second functional material(s) is (are) independently from each other selected from hole injection materials (HIM), hole transport materials (HTM), hole blocking materials (HBM), electron injection materials (EIM), electron transport materials (ETM), electron blocking materials (EBM), exciton blocking materials (ExBM), host materials, emitter materials, metal complexes, and dyes, and wherein the formulation comprises at least one solvent and at least one of the continuous phases comprises at least one host material selected from anthracenes, benzanthracenes, indenofluorenes, fluorenes, spirobifluorenes, phenanthrenes, dehydrophenanthrenes, thiophenes, triazines, imidazole, ketones, carbazoles, triarylamines, and derivatives thereof.

The term functional material preferably refers to organic functional materials. The term organic functional materials refers to organic conductors, organic semiconductors, organic dyes, organic fluorescent compounds, organic phosphorescent compounds, organic photoabsorbing compounds, organic photosensing compounds, organic photo sensitizer and other organic photocactive compounds. The term organic functional material also includes organo-metallic complexes of transition metals, rare earths, lanthanides and actinides.

The functional material and particularly the organic functional material may be selected from the group of small molecules, polymers, oligomers, or dendrimers, blends or mixtures thereof.

In principle a plurality of functional materials can be present in both the discontinuous phases and the continuous phases of the formulations of the present invention. Preferably a continuous phase according to the present invention comprises 4, particularly preferably 3, and very particularly preferably 2 functional materials. In another particular preferred embodiment of the present invention the continuous phase comprises one functional material.

Preferably a discontinuous phase of according to the present invention comprises 4, particularly preferably 3, and very particularly preferably 2 functional materials. In another particular preferred embodiment of the present invention the discontinuous phase comprises one functional material.

Preferably the formulation comprises one continuous phase. In another preferred embodiment the formulation comprises one continuous phase and two discontinuous phases.

The present invention relates to a formulation comprising at least one continuous phase and at least one discontinuous phase, characterized in that at least one of the continuous phases comprises at least one first functional material and wherein at least one of the discontinuous phases comprises at least one second functional material and wherein the first and second functional material(s) is (are) independently form each other selected from hole injection materials (HIM), hole transport materials (HTM), hole blocking materials (HBM), electron injection materials (EIM), electron transport materials (ETM), electron blocking materials (EBM), exciton blocking materials (ExBM), host materials, emitter materials, metal complexes, and dyes, and wherein the formulation comprises at least one solvent and at least one of the continuous phases comprises at least one host material selected from anthracenes, benzanthracenes, indenofluorenes, fluorenes, spirobifluorenes, phenanthrenes, dehydrophenanthrenes, thiophenes, triazines, imidazole, ketones, carbazoles, triarylamines, and derivatives thereof.

Particularly preferably the first and/or second functional materials are selected from hole injection materials (HIM), hole transport materials (HTM), hole blocking materials (HBM), electron injection materials (EIM), electron transport materials (ETM), electron blocking materials (EBM), exciton blocking materials (ExBM), host materials, emitter materials, and metal complexes.

The emitter materials are preferably selected from the class of organic electroluminescent emitter materials as outlined elsewhere within the present invention. The dyes are preferably selected from compounds employed in conjunction with organic solar cells, organic photovoltaic cells, and dye-sensitized solar cells as described below.

Preferably, the formulation according to the invention comprises at least one surfactant, preferably it comprises 3 surfactants, particularly preferably it comprises 2 surfactants, and very particularly preferably it comprises 1 surfactant. Surfactants can be used to stabilise the emulsion. Surfactants suitable for the present invention include anionic surfactants, nonionic surfactants, cationic surfactants, zwitterionic surfactants, amphoteric surfactants, or combinations thereof.

Non-limiting examples of anionic surfactants suitable for use herein include alkyl and alkyl ether sulfates, sulfated monoglycerides, sulfonated olefins, alkyl aryl sulfonates, primary or secondary alkane sulfonates, alkyl sulfosuccinates, acyl taurates, acyl isethionates, alkyl glycerylether sulfonate, sulfonated methyl esters, sulfonated fatty acids, alkyl phosphates, acyl glutamates, acyl sarcosinates, alkyl sulfoacetates, acylated peptides, alkyl ether carboxylates, acyl lactylates, anionic fluorosurfactants, sodium lauroyl glutamate, and combinations thereof

Anionic surfactants suitable for use according to the present invention include alkyl and alkyl ether sulfates. These materials have the respective formulae ROSO₃M and RO(C₂H₄O)ₓSO₃M, wherein R is alkyl or alkenyl of from about 8 to about 24 carbon atoms, x is 1 to 10, and M is a watersoluble cation such as ammonium, sodium, potassium and triethanolamine. The alkyl ether sulfates are typically made as condensation products of ethylene oxide and monohydric alcohol's having from about 8 to about 24 carbon atoms. Preferably, R has from about 10 to about 18 carbon atoms in both the alkyl and alkyl ether sulfates. The alcohol's can be derived from fats, e. g., coconut oil or tallow, or can be synthetic. Lauryl alcohol and straight chain alcohol's derived from coconut oil are preferred herein. Such alcohol's are reacted with about 1 to about 10, preferably from about 3 to about 5, and particularly preferably about 3, molar proportions of ethylene oxide and the resulting mixture of molecular species having, for example, an average of 3 moles of ethylene oxide per mole of alcohol, is sulfated and neutralized.

Specific examples of alkyl ether sulfates which may be used according to the present invention are sodium and ammonium salts of coconut alkyl triethylene glycol ether sulfate; tallow alkyl triethylene glycol ether sulfate, and tallow alkyl hexaoxyethylene sulfate. Highly preferred alkyl ether sulfates are those comprising a mixture of individual compounds, said mixture having an average alkyl chain length of from about 10 to about 16 carbon atoms and an average degree of ethoxylation of from about 1 to about 4 moles of ethylene oxide.

Preferred anionic surfactants for use according to the present invention include ammonium lauryl sulfate, ammonium laureth sulfate, triethylamine lauryl sulfate, triethylamine laureth sulfate, triethanolamine lauryl sulfate, triethanolamine laureth sulfate, monoethanolamine lauryl sulfate, monoethanolamine laureth sulfate, diethanolamine lauryl sulfate, diethanolamine laureth sulfate, lauric monoglyceride sodium sulfate, sodium lauryl sulfate, sodium laureth sulfate, potassium lauryl sulfate, potassium laureth sulfate, sodium lauryl sarcosinate, sodium lauroyl sarcosinate, lauryl sarcosine, cocoyl sarcosine, ammonium cocoyl sulfate, ammonium lauroyl sulfate, sodium cocoyl sulfate, sodium lauroyl sulfate, potassium cocoyl sulfate, potassium lauryl sulfate, triethanolamine lauryl sulfate, triethanolamine lauryl sulfate, monoethanolamine cocoyl sulfate, monoethanolamine lauryl sulfate, sodium dodecyl sulfate, sodium tridecyl benzene sulfonate, sodium dodecyl benzene sulfonate, and combinations thereof.

Particularly preferred anionic surfactants are selected from alkyl sulfates, alkylbenzyl sulfates, alkyl sulfonates, alkylbenzyl sulfonates, alkyl phosphates, alkyl phosphonates, and alkyl carboxylates, particularly preferably sodium deodecyl sulphate (SDS).

Amphoteric surfactants suitable for use according to the present invention includes those that are broadly described as derivatives of aliphatic secondary and tertiary amines in which the aliphatic radical can be straight or branched chain and wherein one of the aliphatic substituents contains from about 8 to about 18 carbon atoms and one contains an anionic water solubilizing group, e.g., carboxy, sulfonate, sulfate, phosphate, or phosphonate. Examples of compounds falling within this definition are sodium 3-dodecyl-aminopropionate, sodium 3-dodecylaminopropane sulfonate, sodium lauryl sarcosinate, N-alkyltaurines such as the one prepared by reacting dodecylamine with sodium isethionate according to the teaching of US 2658072, N-higher alkyl aspartic acids such as those produced according to the teaching of US 2438091, and the products described in US 2528378.

Cationic surfactants can also be used according to the present invention. Preferred cationic surfactants are selected from cetyl trimethylammonium bromide (CTAB) and other alkyltrimethylammonium salts, cetylpyridinium chloride (CPC), polyethoxylated tallow amine (POEA), benzalkonium chloride (BAC), and benzethonium chloride (BZT).

Suitable nonionic surfactants for use according to the present invention include those described in McCutcheion's Detergents and Emulsifiers, North American edition (1986), Allured Publishing Corp., and McCutcheion's Functional Materials, North American edition (1992), which descriptions are incorporated herein by reference. These nonionic surfactants suitable for use herein include alkyl glucosides, alkyl polyglucosides, polyhydroxy fatty acid amides, alkoxylated fatty acid esters, sucrose esters, amine oxides, and combinations thereof.

Suitable nonionic surfactants for use according to the present invention include condensation products of alkylene oxide groups (hydrophilic in nature) with an organic hydrophobic compound, which may be aliphatic or alkyl aromatic in nature. Preferred classes of nonionic surfactants include:
1) polyethylene oxide condensates of alkyl phenols, e.g., the condensation products of alkyl phenols having an alkyl group containing from about 6 to about 20 carbon atoms in either a straight chain or branched chain configuration, with ethylene oxide, the ethylene oxide being present in amounts equal to from about 10 to about 60 moles of ethylene oxide per mole of alkyl phenol;
2) nonionic surfactants derived from the condensation of ethylene oxide with the product resulting from the reaction of propylene oxide and ethylene diamine products;
3) condensation products of aliphatic alcohol's having from about 8 to about 18 carbon atoms, in either straight chain or branched chain configuration, with ethylene oxide, e.g., a coconut alcohol ethylene oxide condensate having from about 10 to about 30 moles of ethylene oxide per mole of coconut alcohol, the coconut alcohol fraction having from about 10 to about 14 carbon atoms;
4) long chain tertiary amine oxides;
5) long chain tertiary phosphine oxides;
6) long chain dialkyl sulfoxides containing one short chain alkyl or hydroxy alkyl radical of from about 1 to about 3 carbon atoms (usually methyl) and one long hydrophobic chain which include alkyl, alkenyl, hydroxy alkyl, or keto alkyl radicals containing from about 8 to about 20 carbon atoms, from 0 to about 10 ethylene oxide moieties and from 0 to about 1 glyceryl moiety;
7) alkyl polysaccharide (APS) surfactants such as the alkyl polyglycosides, as described in US 4565647, which have a hydrophobic group with about 6 to about 30 carbon atoms and polysaccharide (e.g., polyglycoside) as the hydrophilic group, and optionally have a polyalkylene-oxide group joining the hydrophobic and hydrophilic moieties, wherein the alkyl group (i.e., the hydrophobic moiety) can be saturated or unsaturated, branched or unbranched, and unsubstituted or substituted (e. g., with hydroxy or cyclic rings); and
8) polyethylene glycol (PEG) glyceryl fatty esters, such as those of the formula R(O)OCH2CH(OH)CH₂(OCH₂CH₂)ₙOH wherein n is from about 5 to about 200, preferably from about 20 to about 100, and R is an aliphatic hydrocarbyl having from about 8 to about 20 carbon atoms.

Zwitterionic surfactants suitable for use according to the present invention include those that are broadly described as derivatives of aliphatic quaternary ammonium, phosphonium, and sulfonium compounds, in which the aliphatic radicals can be straight or branched chain, and wherein one of the aliphatic substituents contains from about 8 to about 18 carbon atoms and one contains an anionic group, e.g., carboxy, sulfonate, sulfate, phosphate, or phosphonate.

Other zwitterionic surfactants suitable for use herein include betaines, including high alkyl betaines such as coco dimethyl carboxymethyl betaine, cocoamidopropyl betaine, cocobetaine, lauryl amidopropyl betaine, oleyl betaine, lauryl dimethyl carboxymethyl betaine, lauryl dimethyl alphacarboxyethyl betaine, cetyl dimethyl carboxymethyl betaine, lauryl bis-(2-hydroxyethyl)carboxymethyl betaine, stearyl bis-(2-hydroxypropyl) carboxymethyl betaine, oleyl dimethyl gamma-carboxypropyl betaine, and lauryl bis-(2-hydroxypropyl)alpha-carboxyethyl betaine. The sulfobetaines may be represented by coco dimethyl sulfopropyl betaine, stearyl dimethyl sulfopropyl betaine, lauryl dimethyl sulfoethyl betaine, lauryl bis-(2-hydroxyethyl)sulfopropyl betaine and the like; amidobetaines and amidosulfobetaines, wherein the RCONH(CH₂)₃ radical is attached to the nitrogen atom of the betaine are also useful in this invention.

The discontinous phase of the formulations exists usually in a form of a nanodroplet. The size of the nanodroplets in the formulation is adjustable by the type and the amount of the used surfactant(s). Preferably, sodium dodecylsulfate (SDS) is used in the formulation according to the invention.

The amount of surfactant(s) is preferably in the range from 0.1 to 20 wt%, particularly preferably from 0.2 to 10 wt%, and very particularly preferably from 0.5 to 5 wt%, based on the overall weight of the formulation.

The formulation according to the invention may further comprise at least one co-stabilizer. Hydrophobic compounds used as co-stabilizers osmotically stabilize the formulation according to the invention against Ostwald ripening.

Suitable co-stabilizers (e.g., silanes, organo silanes, siloxanes and long chain esters) as disclosed in DE 198 52 784 may be used in the formulation according to the invention.
Preferably the formulation according to the present invention is an emulsion, wherein both the continuous phase(s) and the discontinuous phase(s) comprise at least one solvent.
In another preferred embodiment of the present invention the formulation is a dispersion, wherein at least one nanodroplet represents a solid nanoparticle which is dispersed in the continuous phase. The dispersion can be obtained, e.g., by removing the solvent or solvents from the discontinuous phase as outlined elsewhere within this invention.

Preferably, the continuous phase comprises a first solvent with high polarity. Particularly preferably the first solvent is selected from of water, alcohol, glycols, ethers, and glycol ethers. Preferably, the discontinuous phase comprises a second solvent, wherein the second solvent is an organic solvent with a lower polarity as compared to the first solvent or a mixture of at least two organic solvents.

The formulation according to the invention may be an oil-in-water emulsion (normal emulsion).

In a further preferred embodiment the continuous phase comprises a first solvent with low polarity, and the discontinuous phase comprises a second solvent with a higher polarity as compared to the first solvent. Preferably the second solvent is selected from water and alcohol, and wherein the first solvent is an organic solvent or a mixture of at least two organic solvents.

Moreover, the formulation according to the invention may be a water-in-oil emulsion (inverse emulsion).

Suitable alcohols are alcohols which 1) are in liquid form at working temperature, and 2) have a boiling point below 200°C, so that it could be removed by heating after the formulation is coated, and 3) if together with water as solvent, are miscible with water, preferably having a solubility in water of more than 2 g/L. The said working temperature means the temperature, at which the formulation is prepared, preferably at room temperature. More details on alcohols can be found in textbooks of organic chemistry or suitable handbooks. Preferred alcohols are for example, but not limited to, alcohols with 1 to 12 C-atoms having a linear or branched alkyl chain, such as methanol, ethanol, iso-propanol, n-propanol, 1-propanol, 2-propanol, 1-butanol, 2-methyl-1-propanol, 2-butanol, 2-methyl-2-propanol, 1-pentanol, 2-methyl-1-butanol, 3-methyl-1-butanol, n-butanol, isobutanol, 1-pentanol, isoamyl alcohol, 2-methyl-1-butanol, neopentyl alcohol, 3-pentanol, 2-pentanol, 3-methyl-2-butanol, and 2-methyl-2-butanol.

In a preferred embodiment of the present invention the concentration of continuous phase in the formulation is in an amount ranging from 10 to 99 wt%, preferably from 20 to 95 wt%, particularly preferably from 40 to 95 wt%, very particularly preferably from 50 to 95 wt%.

In another preferred embodiment the said mixture of at least two organic solvents may comprise 2, 3, 4, 5 or more organic solvents.

Suitable organic solvents comprise ketones, esters, amides, sulphur compounds, nitro compounds, halogenated hydrocarbons and hydrocarbons. Aromatic and heteroaromatic hydrocarbons and chlorinated hydrocarbons are preferred organic solvents.

Particularly preferred organic solvents are, for example, dichloromethane, trichloromethane, monochlorobenzene, o-dichlorobenzene, tetrahydrofuran, anisole, morpholine, toluene, chroloform, o-xylene, m-xylene, p-xylene, 1,4-dioxane, acetone, methylethylketone, 1,2-dichloroethane, 1,1,1-trichloroethane, 1,1,2,2-tetrachloroethane, ethyl acetate, n butyl acetate, dimethylformamide, dimethylacetamide, dimethylsulfoxide, tetralin, decalin, indane and/or mixtures thereof.

In a preferred embodiment either said continuous phase and/or said discontinuous phase comprise(s) further additive to reduce the surface tension, or to improve the film formation. The suitable additive can be preferably referred to, e.g., WO 2003/019693 A2

The formulation according to the present invention can additionally comprise one or more further components like for example surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, or inhibitors.

The term small molecule as used herein is defined as molecule not being a polymer, oligomer, dendrimer, or a blend. In particular, repeating structures are absent in small molecules. The molecular weight of small molecules is typically in the range of polymers with a low number of repeating units, oligomers or less.

The molecular weight of the small molecule is preferably below 4000 g/mol, particularly preferably below 3000 g/mol, and very particularly preferably below 2000 g/mol.

The polymers of the present invention preferably have 10 to 10000, particularly preferably 20 to 5000 and very particularly preferably 50 to 2000 repeat units. Oligomers according to this invention have preferably 2 to 9 repeat units. The branching index of the polymers and oligomers is between 0 (linear polymer without branching) and 1 (completely branched dendrimer). The term dendrimer as used herein is defined according to M. Fischer et al. in Angew. Chem., Int. Ed. 1999, 38, 885).

The molecular weight (MW) of the polymers of the present invention is preferably in the range of 10000 to 2000000 g/mol, particularly preferably in the range of 100000 to 1500000 g/mol, and very particularly preferably in the range of 200000 to 1000000 g/mol. The determination of MW can be performed according to standard techniques known to the person skilled in the art by employing gel permeation chromatography (GPC) with polystyrene as internal standard, for instance.

A blend is a mixture comprising at least one polymeric dendrimeric, or oligomeric component.

According to a further preferred embodiment of the present invention the first functional material is insoluble in the solvent of the discontinuous phase and the second functional material is insoluble in the solvent of the continuous phase. Within the meaning of the present invention a material or compound is insoluble in a solvent if its solubility at 25°C is less than 0.4 g/100 ml, preferably less than 0.1 g/100 ml, particularly preferably less than 0.001 g/100 ml.

In another subject of the present invention the formulation, if the formulation is an emulsion, is characterized in that the discontinuous phase forms nanodroplets having an average diameter in the range of 1 to 7000 nm, preferably in the range of 1 to 3000 nm, particularly preferably in the range of 5 to 2000 nm, and very particularly preferably in the range of 5 to 1000 nm.

A miniemulsion is characterized in that the average diameter of the nanodroplets is in the range between 1 and 7000 nm, preferably between 10 to 2000 nm, particularly preferably between 10 to 500 nm, very particularly preferably between 10 to 300 nm, and still more very particularly preferably between 20 and 100 nm. The term emulsion as used herein refers to, depending on the average size of the nanodroplets, both emulsions and miniemulsions.

In another subject of the present invention the formulation, if the formulation is a dispersion, is characterized in that the discontinuous phase forms nanoparticles having an average diameter in the range of 1 to 5000 nm, preferably in the range of 1 to 2000 nm, particularly preferably in the range of 5 to 500 nm, and very particularly preferably in the range of 10 to 300 nm, still more very particularly preferably in the range of 20 to 100 nm.

In yet another embodiment of the present invention the formulation, if the formulation is either an emulsion or dispersion, is characterized in that the discontinuous phase forms nanodroplets or nanoparticles wherein more than 75% of the nanodroplets, preferably more than 80%, particularly preferably more than 90%, and very particularly preferably more than 98% have an average diameter that deviates from the mean of all average diameters of the nanodroplets by 55% or less, preferably 50% or less, particularly preferably 20% or less, and very particularly preferably 10% or less.

The size and size distribution of nanodroplets and nanoparticles emulsions and dispersions, respectively, can be measured employing standard techniques known to one skilled in the art. Dynamic light scattering can be used to measure both parameters (Chu, B. Laser Light scattering: Basic Principles and Practice, 2nd Edition. Academic Press (1992)).

Organic functional materials, i.e. both first and second organic functional materials, according to this invention are often characterized by their molecular frontier orbitals, i.e. the highest occupied molecular orbital (HOMO) (sometimes also referred to as valence band) and the lowest unoccupied molecular orbital (LUMO)(sometimes also referred to as conduction band). The HOMO and LUMO levels are routinely measured (by e.g. XPS = X-ray photoelectron spectroscopy, UPS=ultra-violet photoelectron spectroscopy or CV=cyclovoltammetry) or calculated (by quantum chemical methods such as (time dependent) DFT= density functional theory) which are known to the person skilled in the art. One skilled in the art is also aware of the fact that absolute values of these energy levels significantly depend on the method used. The applicants established a consistent combination method to determine the energy levels of organic semiconductors. The HOMO/LUMO levels of a set of semiconductors (more than 20 different semiconductors) are measured by CV with a reliable evaluation method and also calculated by the DFT of Gaussian 03W with the same correction functional, for example B3PW91 and the same basis set, for example 6-31 G(d). The calculated values are then calibrated according to the measured values. Such calibration factor is used for further calculation. The agreement between calculated and measured values is very good. Therefore, the comparison of the energy levels of this invention is set on a sound base. The energy gaps or band gaps are obtained by the difference between HOMO and LUMO energy levels.

The formulations according to the invention may comprise one or more organic functional materials selected from hole injection materials (HIM). A HIM refers to a material or unit capable of facilitating holes (i.e. positive charges) injected from an anode into an organic layer or an anode. Typically, a HIM has a HOMO level comparable to or higher than the work function of the anode, i.e. - 5.3 eV or higher.

The formulations according to the invention may comprise one or more organic functional materials selected from hole transport materials (HTM). A HTM is characterized in that it is a material or unit capable of transporting holes (i.e. positive charges) injected from a hole injecting material or an anode. A HTM has usually high HOMO, typically higher than -5.4 eV. In many cases, HIM can functions also as HTM, depending on the adjacent layer.

The formulations according to the invention may comprise one or more organic functional materials selected from hole blocking materials (HBM). A HBM refers to a material which, if deposited adjacent to an emissive layer or a hole transporting layer in a multilayer structure, prevents the holes flowing through. Usually it has a lower HOMO as compared to the HOMO level of the HTM in the adjacent layer. Hole-blocking layers are frequently inserted between the light-emitting layer and the electron-transport layer in OLEDs.

The formulations according to the invention may comprise one or more organic functional materials selected from electron injection materials (EIM). An EIM refers to a material capable of facilitating electrons (i.e. negative charges) injected from cathode into an organic layer. The EIM usually has a LUMO level comparable to or lower than the working function of cathode. Typically, the EIM has a LUMO lower than -2.6 eV.

The formulations according to the invention may comprise one or more organic functional materials selected from electron transport materials (ETM). An ETM refers to a material capable of transporting electrons (i.e. negative charges) injected from an EIM or a cathode. The ETM has usually a low LUMO, typically lower than -2.7 eV. In many cases, an EIM can serve as ETM as well, depending on the adjacent layer.

The formulations according to the invention may comprise one or more organic functional materials selected from electron blocking materials (EBM). An EBM refers to a material which, if deposited adjacent to an emissive or electron transporting layer in a multilayer structure, prevents the electron flowing through. Usually it has a higher LUMO as compared to the LUMO of the ETM in the adjacent layer.

The formulations according to the invention may comprise one or more organic functional materials selected from exciton blocking materials (ExBM). An ExBM refers to a material which, if deposited adjacent to an emissive layer in a multilayer structure, prevents the excitons diffuse through. ExBM should have either a higher triplet level or singlet level as compared to the emissive layer or other adjacent layer.

The formulations according to the invention may comprise one or more organic functional materials selected from emitters. The term emitter refers to a material which, upon receiving excitonic energy by any kind of energy transfers from other materials, or by forming an exciton either electrically or optically, undergoes radiative decay to emit light. There are two classes of emitters, fluorescent and phosphorescent emitters. The term fluorescent emitter relates to materials or compounds which undergo a radiative transition from an excited singlet state to its ground. The term phosphorescent emitter, as used herein, relates to luminescent materials or compounds which comprise transition metals. This typically includes materials emitting light caused by spin forbidden transition(s), e.g., transitions from excited triplet states.

The term dopant as employed herein is also used for the term emitter or emitter material.

In the formulations according to the present invention at least one of the continuous phases comprises at least one host material selected from anthracenes, benzanthracenes, indenofluorenes, fluorenes, spirobifluorenes, phenanthrenes, dehydrophenanthrenes, thiophenes, triazines, imidazole, ketones, carbazoles, triarylamines, and derivatives thereof. Said host materials are usually used in combination with emitter and have, in general, larger energy gaps between the HOMO and the LUMO as compared to emitter materials. Said host materials behave either as electron or hole transport material. In case singlet transitions are predominantly responsible for photoluminescence in OLEDs, a maximal overlap between the absorption spectrum of the emitter with the photoluminescence spectrum of the host material is highly desirably. This ensures the energy transfer from the host material to the emitter.

Host material is also called matrix or matrix material, particularly if a host is meant which is used in combination with a phosphorescent emitter in an OLEDs. And for copolymer, comprising emitter unit, the polymer backbone has the same mean as host.

The formulations according to the invention may comprise one or more organic functional materials selected from metal complexes. According to quantum mechanics the transition from excited states with high spin multiplicity, e.g. from excited triplet states, to ground state is forbidden. However, the existence of an heavy atom, for example iridium, osmium, platinum and europium, results in a strong spin-orbit coupling, i.e. the excited singlet and triplet are mixed so that triplet gains some singlet character; and if singlet -triplet mixing yields a radiative decay rate faster than the non-radiative event, then the luminance can be efficient. This kind of emission can be achieved using metal complex, as firstly reported by Baldo et al.; Nature 395, 151-154 (1998). Further metal complexes can also function as efficient and broad-band light absorbing materials or dyes, as for example Ru complex reported by B. O'Regan & M. Graetzel, Nature 353, 737 (1991).

The formulations according to the invention may comprise one or more organic functional materials selected from dyes. A dye can generally be described as an inorganic or organic substance that absorbs light and, therefore, appears colored. The definition of dyes as light absorbing materials which harvest light in order to transmit the light energy to further materials either as light or in any other kind of converted energy.

Further to HIMs mentioned elsewhere herein, suitable HIMs are phenylenediamine derivatives (US 3615404), arylamine derivatives (US 3567450), amino-substituted chalcone derivatives (US 3526501), styrylanthracene derivatives (JP Showa 54 (1979) 110837), hydrazone derivatives (US 3717462), acylhydrazones, stilbene derivatives (JP Showa 61 (1986) 210363), silazane derivatives (US 4950950), polysilane compounds (JP Heisei 2 (1990) 204996), PVK and other electrically conductive macromolecules, aniline-based copolymers (JP Heisei 2 (1990) 282263), electrically conductive, macromolecular thiophene oligomers (JP Heisei 1 (1989) 211399), PEDOT:PSS (spin-coated polymer), plasma-deposited fluorocarbon polymers (US 6127004, US 6208075, US 6208077), porphyrin compounds (JP Showa 63 (1988) 2956965, US 4720432), aromatic tertiary amines and styrylamines (US 4127412), triphenylamines of the benzidine type, triphenylamines of the styrylamine type, and triphenylamines of the diamine type. Arylamine dendrimers can also be used (JP Heisei 8 (1996) 193191), as can phthalocyanine derivatives, naphthalocyanine derivatives, or butadiene derivatives, are also suitable.

Preferably, the HIM is selected from monomeric organic compound comprising amine, triarylamine, thiophene, carbazole, phthalocyanine, porphyrine and their derivatives.

Particular preference is given to the tertiary aromatic amines (US 2008/0102311 A1), for example N,N'-diphenyl-N,N'-di(3-tolyl)-benzidine (= 4,4'-bis[N-3-methylphenyl]-N-phenylamino)biphenyl (NPD) (US 5061569), N,N'-bis(N,N'-diphenyl-4-aminophenyl)-N,N-diphenyl-4,4'-diamino-1,1'-biphenyl (TPD 232) and 4,4',4"-tris[3-methylphenyl)phenylamino]-triphenylamine (MTDATA) (JP Heisei 4 (1992) 308688) or phthalocyanine derivatives (for example H2Pc, CuPc, CoPc, NiPc, ZnPc, PdPc, FePc, MnPc, ClAlPc, ClGaPc, ClInPc, ClSnPc, Cl2SiPc, (HO)AlPc, (HO)GaPc, VOPc, TiOPc, MoOPc, GaPc-O-GaPc).

Particular preference is given to the following triarylamine compounds of the Formulae 1 (TPD 232), 2, 3, and 4, which may also be substituted, and further compounds as disclosed in US 7399537 B2, US 2006/0061265 A1, EP 1661888 A1, and JP 08292586 A. Further compounds suitable as hole injection material are disclosed in EP 0891121 A1 and EP 1029909 A1. Hole injection layers in general are described in US 2004/0174116.

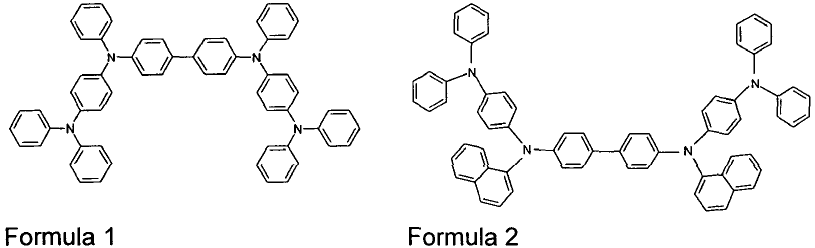

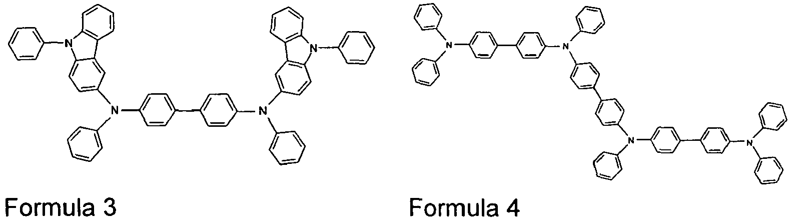

In principle any HTM known to one skilled in the art can be employed in formulations according to the present invention. Further to HTM mentioned elsewhere herein, HTM is preferably selected from amines, triarylamines, thiophenes, carbazoles, phthalocyanines, porphyrines, isomers and derivatives thereof. HTM is particularly preferably selected from amines, triarylamines, thiophenes, carbazoles, phthalocyanines, and porphyrines.

Suitable materials for hole-transporting layers are phenylenediamine derivatives (US 3615404), arylamine derivatives (US 3567450), amino-substituted chalcone derivatives (US 3526501), styrylanthracene derivatives (JP A 56-46234), polycyclic aromatic compounds (EP 1009041), polyarylalkane derivatives (US 3615402), fluorenone derivatives (JP A 54-110837), hydrazone derivatives (US 3717462), stilbene derivatives (JP A 61-210363), silazane derivatives (US 4950950), polysilanes (JP A 2-204996), aniline copolymers (JP A 2-282263), thiophene oligomers, polythiophenes, PVK, polypyrroles, polyanilines and further copolymers, porphyrin compounds (JP A 63-2956965), aromatic dimethylidene-type compounds, carbazole compounds, such as, for example, CDBP, CBP, mCP, aromatic tertiary amine and styrylamine compounds (US 4127412), and monomeric triarylamines (US 3180730). Even more triarylamino groups may also be present in the molecule. Preference is given to aromatic tertiary amines containing at least two tertiary amine units (US 4720432 and US 5061569), such as, for example, 4,4'-bis[N-(1-naphthyl)-N-phenylamino]biphenyl (NPD) (US 5061569) or MTDATA (JP A 4-308688), N,N,N',N'-tetra(4-biphenyl)diaminobiphenylene (TBDB), 1,1-bis(4-di-p-tolylaminophenyl)cyclohexane (TAPC), 1,1-bis(4-dip-tolylaminophenyl)-3-phenylpropane (TAPPP), 1,4-bis[2-[4-[N,N-di(p-tolyl)amino]phenyl]vinyl]benzene (BDTAPVB), N,N,N',N'-tetra-p-tolyl-4,4'-diaminobiphenyl (TTB), TPD, N,N,N',N'-tetraphenyl-4,4"'-diamino-1,1':4',1":4",1"'-quaterphenyl, likewise tertiary amines containing carbazole units, such as, for example, 4 (9H-carbazol-9-yl)-N,N-bis[4-(9H-carbazol-9-yl)phenyl]benzeneamine (TCTA). Preference is likewise given to hexaazatriphenylene compounds in accordance with US 2007/0092755 A1.

Particular preference is given to the following triarylamine compounds of the Formulae 5 to 10, which may also be substituted, and as disclosed in EP 1162193 A1, EP 650955 A1, Synth. Metals 1997, 91(1-3), 209, DE 19646119 A1, WO 2006/122630 A1, EP 1860097 A1, EP 1834945 A1, JP 08053397 A, US 6251531 B1, and WO 2009/041635.

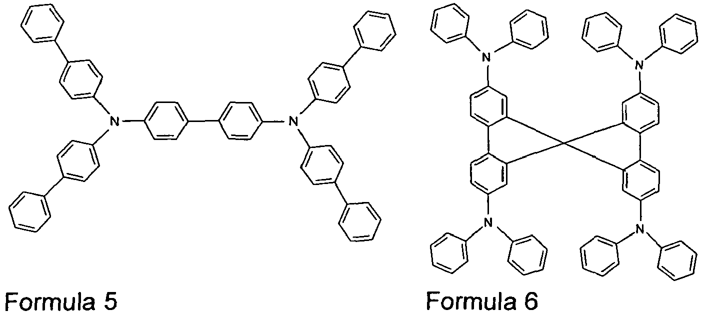

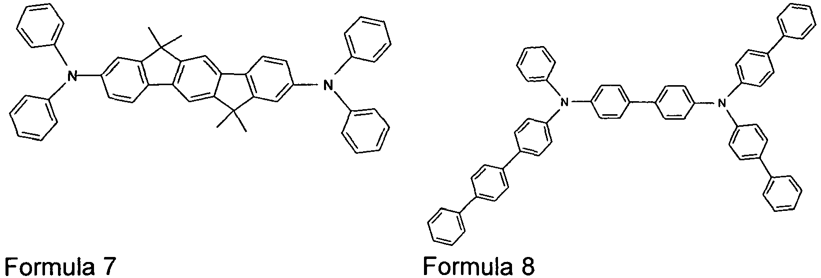

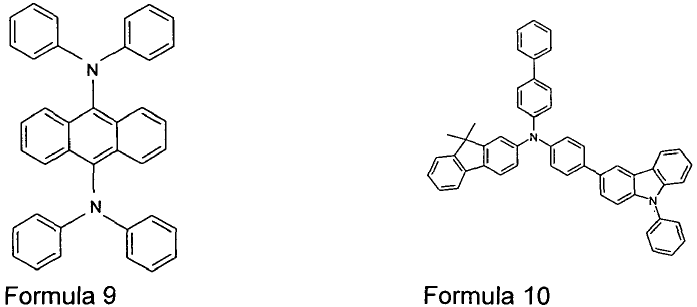

In principle any HBM known to one skilled in the art can be employed in formulations according to the present invention. Further to HBM mentioned elsewhere herein, suitable hole-blocking materials are metal complexes (US 2003/0068528), such as, for example, bis(2-methyl-8-quinolinolato)(4-phenylphenolato)-aluminium(III) (BAIQ). Fac-tris(1-phenyl-pyrazolato-N,C2)iridium(III) (Ir(ppz)₃) is likewise used for this purpose (US 2003/0175553 A1). Phenanthroline derivatives, such as, for example, BCP, or phthalimides, such as, for example, TMPP, are likewise employed.

Further, suitable hole-blocking materials are described in WO 00/70655 A2, WO 01/41512 and WO 01/93642 A1.

In principle any EIM known to one skilled in the art can be employed in formulations according to the present invention. Further to EIM mentioned elsewhere herein, suitable EIM elsewhere herein, ElMs, which comprises at least one organic compound selected from metal complexes of 8-hydroxyquinoline, heterocyclic organic compounds, fluorenones, fluorenylidene methane, perylenetetracarboxylic acid, anthraquinone dimethanes, diphenoquinones, anthrones, anthraquinonediethylene-diamines, isomers and derivates thereof can be used according to the invention.

Metal complexes of 8 hydroxyquinoline, such as, for example, Alq₃ and Gaq₃, can be used as EIM for electron-injection layers. A reducing doping with alkali metals or alkaline-earth metals, such as, for example, Li, Cs, Ca or Mg, at the interface to the cathode is advantageous. Preference is given to combinations which include Cs, for example Cs and Na, Cs and K, Cs and Rb or Cs, Na and K.

Heterocyclic organic compounds, such as, for example, 1,10-phenanthroline derivatives, benzimidazoles, thiopyran dioxides, oxazoles, triazoles, imidazoles or oxadiazoles, are likewise suitable. Examples of suitable five-membered rings containing nitrogen are oxazoles, thiazoles, oxadiazoles, thiadiazoles, triazoles, and compounds which are disclosed in US 2008/0102311 A1.

Preferred ElMs are selected from compounds with the Formulae 11 to 13, which may be substituted or unsubstituted.

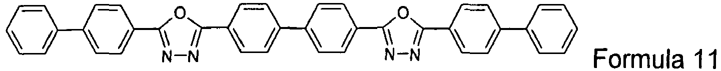

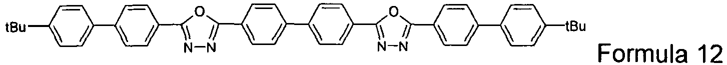

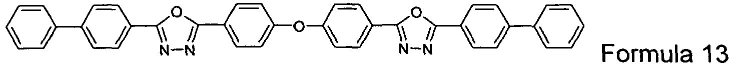

Organic compounds, such as fluorenones, fluorenylidene methane, perylenetetracarboxylic acid, anthraquinone dimethanes, diphenoquinones, anthrones and anthraquinonediethylenediamines, can also be employed, for example

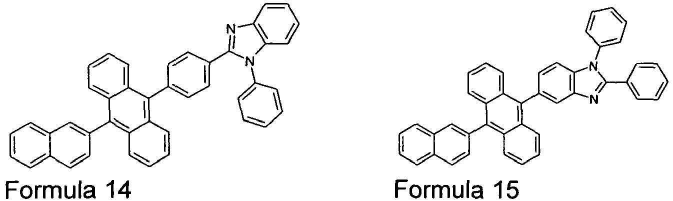

In principle any ETM known to one skilled in the art can be employed in formulations according to the present invention. Further to ETM mentioned elsewhere herein, suitable ETM is selected from the group consisting of imidazoles, pyridines, pyrimidines, pyridazines, pyrazines, oxadiazoles, chinolines, chinoxalines, anthracenes, benzanthracenes, pyrenes, perylenes, benzimidazoles, triazines, ketones, phosphinoxides, phenazines, phenanthrolines, triarylboranes, isomers and derivatives thereof.

Suitable ETMs for electron-transporting layers are metal chelates of 8 hydroxyquinoline (for example Liq, Alq₃, Gaq₃, Mgq₂, Znq₂, Inq₃, Zrq₄), Balq, 4 azaphenanthrene-5-ol/Be complexes (US 5529853 A; e.g. Formula 16), butadiene derivatives (US 4356429), heterocyclic optical brighteners (US 4539507), benzazoles, such as, for example, 1,3,5-tris(2-N-phenylbenzimidazolyl)benzene (TPBI) (US 5766779, Formula 17), 1,3,5-triazines, pyrenes, anthracenes, tetracenes, fluorenes, spirobifluorenes, dendrimers, tetracenes, for example rubrene derivatives, 1,10-phenanthroline derivatives (JP 2003/115387, JP 2004/311184, JP 2001/267080, WO 2002/043449), silacyl-cyclopentadiene derivatives (EP 1480280, EP 1478032, EP 1469533), pyridine derivatives (JP 2004/200162 Kodak), phenanthrolines, for example BCP and Bphen, also a number of phenanthrolines bonded via biphenyl or other aromatic groups (US 2007/0252517 A1) or phenanthrolines bonded to anthracene (US 2007/0122656 A1, e.g. Formulae 18 and 19), 1,3,4-oxadiazoles, for example Formula 20, triazoles, for example Formula 21, triarylboranes, for example also with Si (e.g. Formula 48), benzimidazole derivatives and other N heterocyclic compounds (cf. US 2007/0273272 A1), silacyclopentadiene derivatives, borane derivatives, Ga oxinoid complexes.

Preference is given to 2,9,10-substituted anthracenes (with 1- or 2-naphthyl and 4- or 3-biphenyl) or molecules which contain two anthracene units (US 2008/0193796 A1).

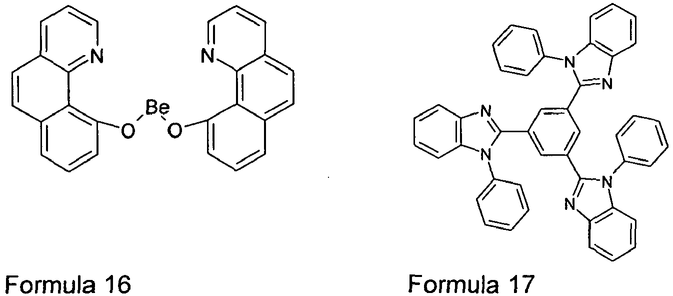

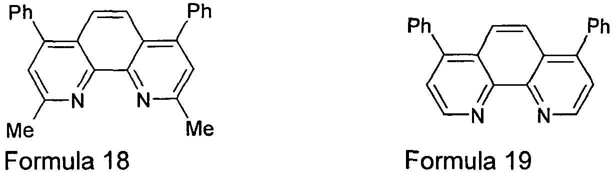

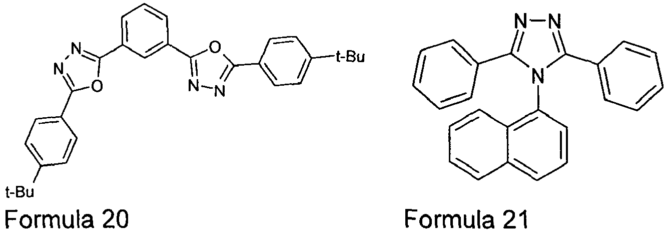

Preference is likewise given to anthracene-benzimidazole derivatives, such as, for example, the compounds of Formulae 22 to 24, and as disclosed in, e.g., US 6878469 B2, US 2006/147747 A, and EP 1551206 A1.

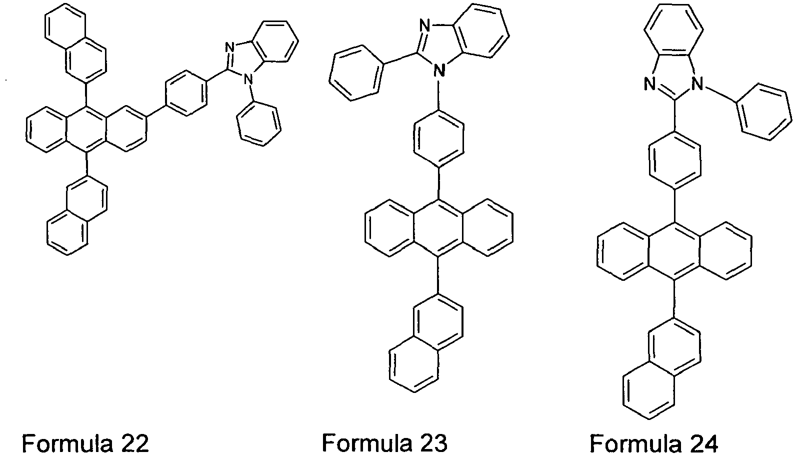

In principle any EBM known to one skilled in the art can be employed in formulations according to the present invention. Further to EBM mentioned elsewhere herein, transition-metal complexes, such as, for example, Ir(ppz)₃ (US 2003/0175553) can be employed as materials for an electron-blocking layer.

Preferably, the EBM is further selected from amines, triarylamines and their derivatives.

It is known to a person skilled in the art that the selection of ExBMs suitable for formulations according to the present invention depends on the energy gap of the adjacent layer. Suitable ExBMs are supposed to have a bigger energy gap, either singlet or triplet than the functional material in the adjacent layer which is preferably an emissive layer. Further to ExBMs mentioned elsewhere herein, substituted triarylamines, such as, for example, MTDATA or 4,4',4"-tris(N,N-diphenylamino)-triphenylamine (TDATA), can be used as ExBM for electron-blocking layers. Substituted triarylamines are described, for example, in US 2007/0134514 A1.

N-substituted carbazole compounds, such as, for example, TCTA, or heterocycles, such as, for example, BCP, are also suitable.

Metal complexes, such as, for example, Ir(ppz)₃ or Alq₃, can likewise be used for this purpose.

In the formulations according to the present invention at least one of the continuous phases comprises at least one host material selected from anthracenes, benzanthracenes, indenofluorenes, fluorenes, spirobifluorenes, phenanthrenes, dehydrophenanthrenes, thiophenes, triazines, imidazole, ketones, carbazoles, triarylamines, and derivatives thereof. Depending on the kind of emitter employed host materials can be separated into two categories, hosts for fluorescent emitter and hosts for phosphorescent emitter, whereby the latter is often referred to as matrix or matrix material. Formulations according to the present invention may also comprise more than one host material, preferably it comprises 3 host materials, particularly preferably it comprises 2 host materials, and very particularly preferably one host material. If a formulation according to this invention comprises at least two host materials, the host materials are also referred to as co-host or co-host materials.

The host materials suitable for fluorescent emitter are selected from anthracenes, benzanthracenes, indenofluorenes, fluorenes, spirobifluorenes, phenanthrenes, dehydrophenanthrenes, thiophenes, triazines, imidazole and derivatives thereof.

Particularly preferred host materials for fluorescent emitter are selected from the classes of anthracenes, fluorenes, spirobifluorenes, phenanthrenes (for example 2,2',7,7'-tetraphenyl-spirobifluorene in accordance with EP 676461 or dinaphthylanthracene), or the benzanthracenes (e.g. DE 102007024850). Particularly preferred host materials are selected from the classes of the anthracene, benzanthracene and ketones. Very particularly preferred host materials are selected from anthracene and benzanthracene. An oligoarylene is intended to be taken to mean a compound in which at least three aryl or arylene groups are bonded to one another.

Anthracene-based compounds are described in US 2007/0092753 A1 and US 2007/0252517 A1, for example 2-(4-methylphenyl)-9,10-di-(2-naphthyl)anthracene, 9-(2-naphthyl)-10-(1,1'-biphenyl)anthracene and 9,10-bis[4-(2,2-diphenylethenyl)phenyl]anthracene, 9,10-diphenylanthracene, 9,10-bis(phenylethynyl)anthracene and 1,4-bis(9'-ethynylanthracenyl)benzene. Preference is also given to host materials containing two anthracene units (US 2008/0193796 A1), for example 10,10'-bis[1,1',4',1"]terphenyl-2-yl-9,9'-bisanthracenyl.

Further preferred host materials are derivatives of triarylamine and imidazole (US 2007/0092753 A1), for example 2,2',2"-(1,3,5-phenylene)tris[1-phenyl-1H-benzimidazole], and anthracene and/or benzanthracene compounds having the Formulae 26 to 32.

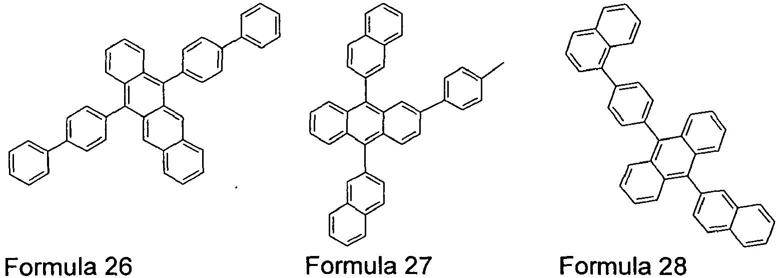

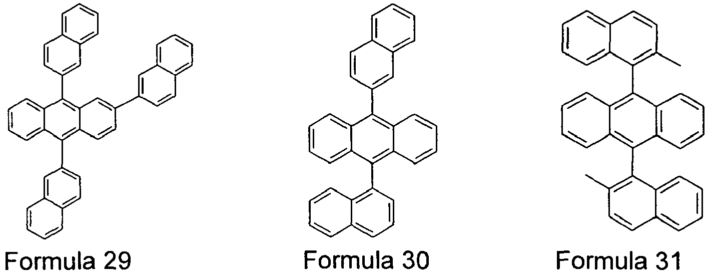

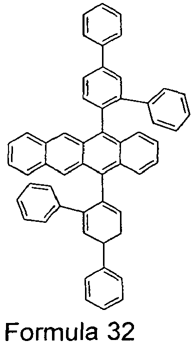

Further host materials for fluorescent emitter are selected from spirobifluorene and derivates thereof, for example Spiro-DPVBi as disclosed in EP 0676461 and indenofluorene as disclosed in US 6562485.

The host materials for phosphorescent emitter, i.e. matrix materials, are selected from ketones, carbazoles, triarylamines, indenofluorenes, fluorenes, spirobifluorenes, phenathrenes, dehydrophenanthrenes, thiophenes, triazines, imidazoles and their derivatives. Some preferred derivatives are described below in more details.

If a phosphorescent emitter is employed, e.g. as electroluminescent component in organic light emitting diodes (OLEDs), the host material must fulfil rather different characteristics as compared to host materials used for fluorescent emitter. The host materials used for phosphorescent emitter are required to have a triplet level which is higher in energy as compared to the triplet level of the emitter. The host material can either transport electrons or holes or both of them. In addition, the emitter is supposed to have large spin-orbital coupling constants in order to facilitate singlet-triplet mixing sufficiently. This can be enabled by using metal complexes.

Preferred matrix materials are N,N-biscarbazolylbiphenyl (CBP), carbazole derivatives (for example in accordance with WO 2005/039246, US 2005/0069729, JP 2004/288381, EP 1205527 or DE 102007002714), azacarbazoles (for example in accordance with EP 1617710, EP 1617711, EP 1731584, JP 2005/347160), ketones (for example in accordance with WO 2004/093207), 9,9-diarylfluorene derivatives (e.g. in accordance with DE 102008017591), imidazole derivatives, tertiary aromatic amines, anthrone derivatives, fluorenone derivatives, Examples of preferred carbazole derivatives are, 1,3-N,N-dicarbazole-benzene (= 9,9'-(1,3-phenylene)bis-9H-carbazole) (mCP), 9,9'-(2,2'-dimethyl[1,1'-biphenyl]-4,4'-diyl)bis-9H-carbazole (CDBP), 1,3-bis(N,N'-dicarbazole)benzene (= 1,3-bis(carbazol-9-yl)benzene), PVK (polyvinyl-carbazole), 3,5-di(9H-carbazol-9-yl)biphenyl and compounds of the Formulae 40 to 44.

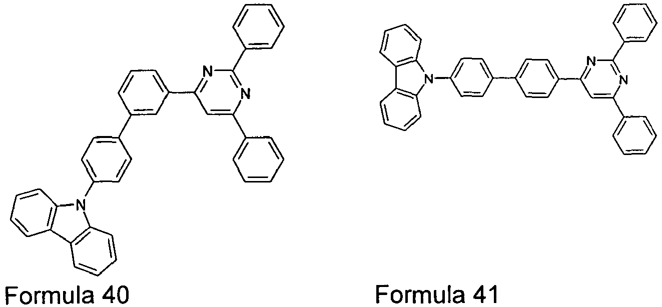

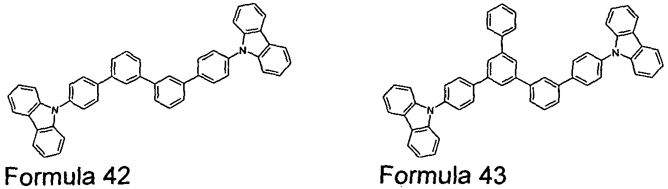

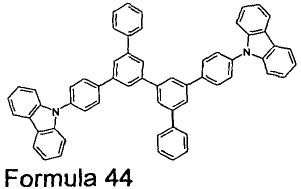

The emitter compound is required to have a smaller band gap as compared to the host compound. In general, smaller band gaps can be achieved by extending the π-electron system of conjugated molecular systems. Emitter compounds tend, therefore, to have more extended conjugated π-electron systems than host molecules. Many examples have been published, e.g. styrylamine derivatives as disclosed in JP 2913116B and WO 2001/021729 A1, and indenofluorene derivatives as disclosed in WO 2008/006449 and WO 2007/140847.

Blue fluorescent emitters are preferably polyaromatic compounds, such as, for example, 9,10-di(2-naphthylanthracene) and other anthracene derivatives, derivatives of tetracene, xanthene, perylene, such as, for example, 2,5,8,11-tetra-t-butylperylene, phenylene, for example 4,4'-(bis(9-ethyl-3-carbazovinylene)-1,1'-biphenyl, fluorene, arylpyrenes (US 2006/0222886), arylenevinylenes (US 5121029, US 5130603), derivatives of rubrene, coumarine, rhodamine, quinacridone, such as, for example, N,N'-dimethylquinacridone (DMQA), dicyanomethylenepyrane, such as, for example, 4 (dicyanoethylene)-6-(4-dimethylaminostyryl-2-methyl)-4H-pyrane (DCM), thiopyrans, polymethine, pyrylium and thiapyrylium salts, periflanthene, indenoperylene, bis(azinyl)imine-boron compounds (US 2007/0092753 A1), bis(azinyl)methene compounds and carbostyryl compounds.

Further preferred blue fluorescent emitters are described in C.H. Chen et al.: "Recent developments in organic electroluminescent materials" Macromol. Symp. 125, (1997), 1-48 and "Recent progress of molecular organic electroluminescent materials and devices" Mat. Sci. and Eng. R, 39 (2002), 143-222.

Preferred fluorescent dopants according to the present invention are selected from the class of the monostyrylamines, the distyrylamines, the tristyrylamines, the tetrastyrylamines, the styrylphosphines, the styryl ethers and the arylamines.

A monostyrylamine is taken to mean a compound which contains one substituted or unsubstituted styryl group and at least one, preferably aromatic, amine. A distyrylamine is taken to mean a compound which contains two substituted or unsubstituted styryl groups and at least one, preferably aromatic, amine. A tristyrylamine is taken to mean a compound which contains three substituted or unsubstituted styryl groups and at least one, preferably aromatic, amine. A tetrastyrylamine is taken to mean a compound which contains four substituted or unsubstituted styryl groups and at least one, preferably aromatic, amine. The styryl groups are particularly preferably stilbenes, which may also be further substituted. The corresponding phosphines and ethers are defined analogously to the amines. For the purposes of this invention, an arylamine or an aromatic amine is taken to mean a compound which contains three substituted or unsubstituted aromatic or heteroaromatic ring systems bonded directly to the nitrogen. At least one of these aromatic or heteroaromatic ring systems is preferably a condensed ring system, preferably having at least 14 aromatic ring atoms. Preferred examples thereof are aromatic anthracene-amines, aromatic anthracene-diamines, aromatic pyrene-amines, aromatic pyrene-diamines, aromatic chrysene-amines and aromatic chrysene-diamines. An aromatic anthracene-amine is taken to mean a compound in which one diarylamino group is bonded directly to an anthracene group, preferably in the 9 position. An aromatic anthracene-diamine is taken to mean a compound in which two diarylamino groups are bonded directly to an anthracene group, preferably in the 9,10-position. Aromatic pyrene-amines, pyrene-diamines, chrysene-amines and chrysene-diamines are defined analogously thereto, where the diarylamino groups on the pyrene are preferably bonded in the 1 position or in the 1,6-position.

Further preferred fluorescent dopants are selected from indenofluorene-amines and indenofluorene-diamines, for example in accordance with WO 2006/122630, benzoindenofluorene-amines and benzoindenofluorene-diamines, for example in accordance with WO 2008/006449, and dibenzoindenofluorene-amines and dibenzoindenofluorene-diamines, for example in accordance with WO 2007/140847.

Examples of dopants from the class of the styrylamines are substituted or unsubstituted tristilbene-amines or the dopants described in WO 2006/000388, WO 2006/058737, WO 2006/000389, WO 2007/065549 and WO 2007/115610. Distyrylbenzene and distyrylbiphenyl derivatives are described in US 5121029. Further styrylamines are found in US 2007/0122656 A1.
Particularly preferred styrylamine dopants and triarylamine dopants are the compounds of the Formulae 53 to 58 and as disclosed in US 7250532 B2, DE 102005058557 A1, CN 1583691 A, JP 08053397 A, US 6251531 B1, and US 2006/210830 A.

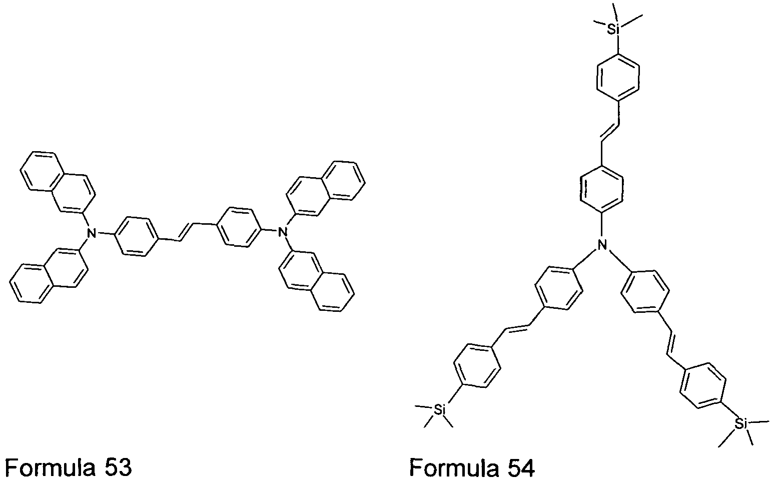

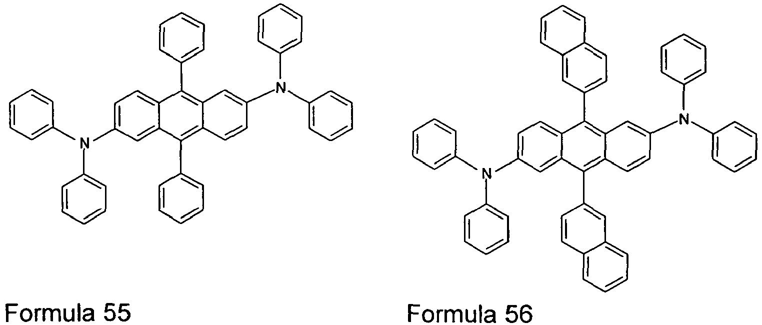

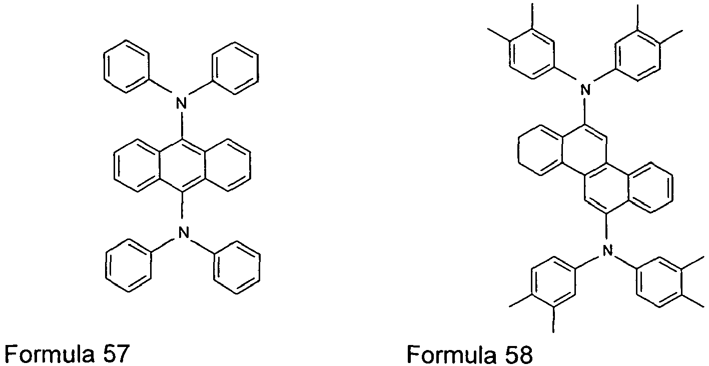

Further preferred fluorescent dopants are selected from the group of triarylamines as disclosed in EP 1957606 A1 and US 2008/0113101 A1.

Further preferred fluorescent dopants are selected from derivatives of naphthalene, anthracene, tetracene, fluorene, periflanthene, indenoperylene, phenanthrene, perylene (US 2007/0252517 A1), pyrene, chrysene, decacyclene, coronene, tetraphenylcyclopentadiene, pentaphenylcyclopentadiene, fluorene, spirofluorene, rubrene, coumarine (US 4769292, US 6020078, US 2007/0252517 A1), pyran, oxazone, benzoxazole, benzothiazole, benzimidazole, pyrazine, cinnamic acid esters, diketopyrrolopyrrole, acridone and quinacridone (US 2007/0252517 A1).

Of the anthracene compounds, particular preference is given to 9,10-substituted anthracenes, such as, for example, 9,10-diphenylanthracene and 9,10-bis(phenylethynyl)anthracene. 1,4-Bis(9'-ethynylanthracenyl)-benzene is also a preferred dopant.

Examples of phosphorescent emitters are revealed by the applications WO 00/70655, WO 01/41512, WO 02/02714, WO 02/15645, EP 1191613, EP 1191612, EP 1191614 and WO 2005/033244. In general, all phosphorescent complexes as used in accordance with the prior art for phosphorescent OLEDs and as are known to the person skilled in the art in the area of organic electroluminescence are suitable, and the person skilled in the art will be able to use further phosphorescent complexes without inventive step.

The phosphorescent emitter may be a metal complex, preferably with the formula M(L)_{z}, wherein M is a metal atom, L is in each occurrence independently of one another an organic ligand that is bonded to or coordinated with M via one, two or more positions, and z is an integer ≥ 1, preferably 1, 2, 3, 4, 5 or 6, and wherein, optionally, these groups are linked to a polymer via one or more, preferably one, two or three positions, preferably via the ligands L.

M is in particular a metal atom selected from transition metals, preferably selected from transition metals of group VIII, or lanthanoides, or actinides, particularly preferably selected from Rh, Os, Ir, Pt, Pd, Au, Sm, Eu, Gd, Tb, Dy, Re, Cu, Zn, W, Mo, Pd, Ag, or Ru, and very particularly preferably selected from Os, Ir, Ru, Rh, Re, Pd, or Pt. M may also be Zn.

Preferred ligands are 2 phenylpyridine derivatives, 7,8-benzoquinoline derivatives, 2 (2-thienyl)pyridine derivatives, 2 (1-naphthyl)pyridine derivatives or 2 phenylquinoline derivatives. All these compounds may be substituted, for example by fluoro- or trifluoromethyl substituents for blue. Auxiliary ligands are preferably acetylacetonate or picric acid.

In particular, complexes of Pt or Pd with tetradentate ligands of the Formula 59 as disclosed in US 2007/0087219 A1, wherein R¹ to R¹⁴ and Z¹ to Z⁵ are as defined in the reference, Pt porphyrin complexes having an enlarged ring system (US 2009/0061681 A1) and Ir complexes are suitable, for example 2,3,7,8,12,13,17,18-octaethyl-21H, 23H-porphyrin-Pt(II), tetraphenyl-Pt(II)-tetrabenzoporphyrin (US 2009/0061681 A1), cis-bis(2-phenylpyridinato-N,C2')Pt(II), cis-bis(2-(2'-thienyl)pyridinato-N,C3')Pt(II), cis-bis(2-(2'-thienyl)quinolinato-N,C5')Pt(II), (2-(4,6-difluorophenyl)pyridinato-N,C2')Pt(II) acetylacetonate, or tris(2-phenylpyridinato-N,C2')Ir(III) (Ir(ppy)₃, green), bis(2-phenylpyridinato-N,C2)Ir(III) acetylacetonate (Ir(ppy)₂ acetylacetonate, green, US 2001/0053462 A1, Baldo, Thompson et al. Nature 403, (2000), 750-753), bis(1-phenylisoquinolinato-N,C2')(2-phenylpyridinato-N,C2')iridium(III), bis(2-phenylpyridinato-N,C2')(1-phenylisoquinolinato-N,C2')iridium(III), bis(2-(2'-benzothienyl)-pyridinato-N,C3')iridium(III) acetylacetonate, bis(2-(4',6'-difluorophenyl)-pyridinato-N,C2')iridium(III) piccolinate (Firpic, blue), bis(2-(4',6'-difluorophenyl)pyridinato-N,C2')Ir(III) tetrakis(1-pyrazolyl)borate, tris(2-(biphenyl-3-yl)-4-tert-butylpyridine)iridium(III), (ppz)₂Ir(5phdpym) (US 2009/0061681 A1), (45ooppz)₂Ir(5phdpym) (US 2009/0061681 A1), derivatives of 2 phenylpyridine-Ir complexes, such as, for example, iridium(III) bis(2-phenylquinolyl-N,C2')acetylacetonate (PQIr), tris(2-phenylisoquinolinato-N,C)Ir(III) (red), bis(2-(2'-benzo[4,5-a]thienyl)pyridinato-N,C3)Ir acetylacetonate ([Btp2Ir(acac)], red, Adachi et al. Appl. Phys. Lett. 78 (2001), 1622-1624).

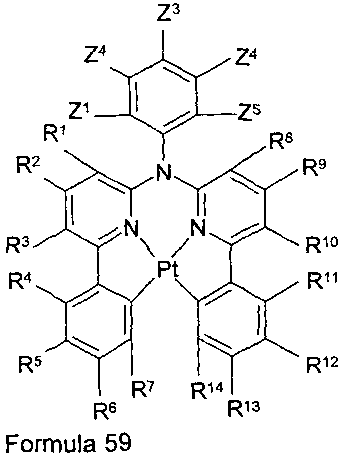

Also suitable are complexes of trivalent lanthanides, such as, for example, Tb³⁺ and Eu³⁺ (J. Kido et al. Appl. Phys. Lett. 65 (1994), 2124, Kido et al. Chem. Lett. 657, 1990, US 2007/0252517 A1), or phosphorescent complexes of Pt(II), Ir(I), Rh(I) with maleonitrile dithiolate (Johnson et al., JACS 105, 1983, 1795), Re(I) tricarbonyl diimine complexes (Wrighton, JACS 96, 1974, 998 inter alia), Os(II) complexes with cyano ligands and bipyridyl or phenanthroline ligands (Ma et al., Synth. Metals 94, 1998, 245) or Alq₃ without a host.

Further phosphorescent emitters with tridentate ligands are described in US 6824895 and US 7029766. Red-emitting phosphorescent complexes are mentioned in US 6835469 and US 6830828.

A particularly preferred phosphorescent dopant is a compound with the Formula 60 and further compounds as disclosed, e.g., in US 2001/0053462 A1.

A particularly preferred phosphorescent dopant is a compound with the Formula 61 and further compounds as disclosed, e.g., in WO 2007/095118 A1

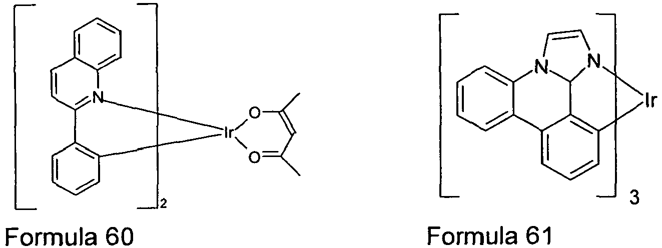

Further derivatives are described in US 7378162 B2, US 6835469 B2, and JP 2003/253145 A.

Further to metal complex mentioned elsewhere herein, a suitable metal complex according to the present invention can be selected from transition metals, rare earth elements, lanthanides and actinides is also subject of this invention. Preferably the metal is selected from Ir, Ru, Os, Eu, Au, Pt, Cu, Zn, Mo, W, Rh, Pd, or Ag.

Further to dyes mentioned elsewhere herein, dyes according to the invention can be selected from perylenes, ruthenium dyes, phthalocyanines, azo dyes, perylene-diimides, porphyrines, squaraines, isomers and derivatives thereof.

Preferably the dye is selected from perylenes, ruthenium dyes, phthalocyanines, azo dyes, perylene-diimides, porphyrines, and squaraines. Also preferred are dyes selected from ruthenium complexes as disclosed by Yu Bai et. al., in Nature Materials, Vol7, 626 (2008) and by B. O'Regan et. al., in Nature 353, 737 (1991), and Cu based complexes as disclosed by Bessho et al, in Chem. Commun. 3717 (2008).

Further dyes are selected from acridines, anthraquinones, arylmethanes, diarylmethanes, triarylmethanes, azo-based dyes, cyanines, diazonium-based dyes, nitro-based dyes, nitroso-based dyes, quinone-imines, azin-based dyes, eurhodines, safranines, indulines, indamins, indophenoles, oxazines, oxazones, thiazines, thiazoles, xanthenes, fluorenes, pyronines, fluorones, and rhodamines.

In addition to dyes according to the present invention, charge generation materials can also have the same function as a dye. They are, for example, used for electrophotographic devices. Thus charge generation materials as summarized by Paul M.Borsenberger; and David S.Weiss in Organic Photorecptors for Xerography; Marcel Dekker, Inc., 1998, Chapter 6, and by K. Y. Law, Chem. Rev. Vol93, 449-486 (1993) are herein also considered as suitable dye.

Further suitable dyes are selected from organic compounds containing fused ring system, for example anthracene, naphthalene, pentacene and tetracence derivatives.

Formulations according to the present invention may also comprise further functional material, i.e. a first and/or a second functional material, which is selected from small molecules, polymers, oligomers, dendrimers, and blends. The functional polymer is characterized in that different functions may be incorporated into one large molecule or a blend of large molecules. The functions are, inter alia, the ones of a hole injection material, hole transport material, electron blocking material, emissive material, hole blocking material, electron injection material, electron transport material, and dye. The functions which are incorporated into a polymer can be categorized into different groups. By choosing the desired functional groups and the ratio between them, the polymer can be tuned to have the desired function(s).

The difference between polymers, oligomers and dendrimers is due to the size, size distribution, and branching of the molecular entities as defined above.

Different structures are, inter alia, those as disclosed and extensively listed in WO 2002/077060 A1 and in DE 10337346 A1. The structural units may originate, for example, from the following groups:
- Group 1:: units which increase the hole-injection and/or transport properties of the polymers; It corresponds to the HIMs or HTMs as described above.
- Group 2:: units which increase the electron-injection and/or transport properties of the polymers; It corresponds to the ElMs or ETMs as described above.
- Group 3:: units which have combinations of individual units from group 1 and group 2;
- Group 4:: units which modify the emission characteristics to such an extent that electrophosphorescence may be obtained instead of electrofluorescence; typically, it corresponds to the phosphorescent emitter, or more preferably emissive metal complexes as described above.
- Group 5:: units which improve the transition from the so called singlet state to higher spin states, e.g. to a triplet state;
- Group 6:: units which influence the morphology and/or emission colour of the resultant polymers;
- Group 7:: units which are typically used as backbone and which may have electron transport function, hole transport function or both.
- Group 8:: units which have strong absorption in at least one wavelength from UV to infrared. It corresponds to the dye materials as described above.

Preferably, the said further organic functional material is a hole transport or injection polymer comprising units of groups 1, which are preferably selected from units comprising the low molecular weight HTMs or HIMs as described above.

Further preferred units from group 1 are, for example, triarylamine, benzidine, tetraaryl-para-phenylenediamine, carbazole, azulene, thio¬phene, pyrrole and furan derivatives and further O , S or N containing heterocycles with a high HOMO. These arylamines and heterocycles preferably result in an HOMO in the polymer of greater than 5.8 eV (against vacuum level), particularly preferably greater than 5.5 eV.

Preferred polymeric HTM or HIM is a polymer comprising at least one of following repeat unit according to Formulae 62. 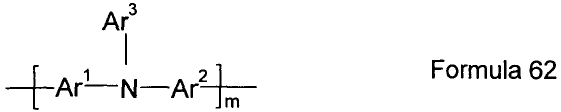 wherein
Ar¹ which may be the same or different, denote, independently if in different repeat units, a single bond or an optionally substituted mononuclear or polynuclear aryl group,
Ar² which may be the same or different, denote, independently if in different repeat units, an optionally substituted mononuclear or polynuclear aryl group,
Ar³ which may be the same or different, denote, independently if in different repeat units, an optionally substituted mononuclear or polynuclear aryl group,
m is 1, 2 or 3.

Particularly preferred units of Formula 62 are selected from the group consisting of the Formulae 63 to 65: 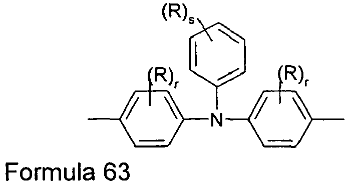 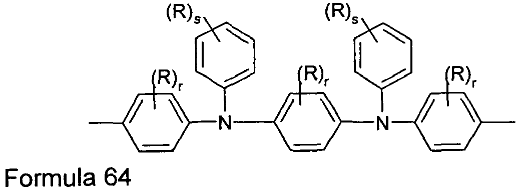 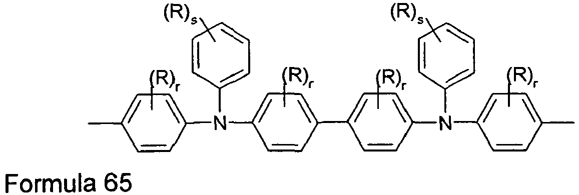 wherein
R which may be the same or different in each occurrence, is selected from H, substituted or unsubstituted aromatic or heteroaromatic group, alkyl, cycloalkyl,alkoxy, aralkyl, aryloxy, arylthio, alkoxycarbonyl, silyl, carboxy group, a halogen atom, cyano group, nitro group or hydroxy group,
r is 0, 1, 2, 3 or 4, and
s is 0, 1, 2, 3, 4 or 5.

Further preferred polymeric HTM or HIM is a polymer comprising at least one of following repeat unit according to Formulae 66.

-(T¹)_{c}-(Ar⁴)_{d}-(T²)ₑ-(Ar⁵)_{f}- Formula 66

wherein
T¹ and T² are independently of each other selected from thiophene, selenophene, thieno[2,3b]thiophene, thieno[3,2b]thiophene, dithienothiophene, pyrrole, aniline , all of which are optionally substituted with R⁵,
R⁵ is in each occurrence independently of each other selected from halogen, -CN, -NC, -NCO, -NCS, -OCN, SCN, C(=O)NR⁰R⁰⁰, -C(=O)X,-C(=O)R⁰, -NH₂, -NR⁰R⁰⁰, SH, SR⁰, -SO₃H, -SO₂R⁰, -OH, -NO₂, -CF₃, -SF₅, optionally substituted silyl, or carbyl or hydrocarbyl with 1 to 40 C atoms that is optionally substituted and optionally contains one or more hetero atoms,
Ar⁴ and Ar⁵ are independently of each other mononuclear or polynuclear aryl or heteroaryl, which is optionally substituted and optionally fused to the 2,3-positions of one or both of the adjacent thiophene or selenophene groups,
c and e are independently of each other 0, 1, 2, 3 or 4, with 1 < c + e ≤ 6,
d and f are independently of each other 0, 1, 2, 3 or 4.

Examples for polymeric HTMs are as disclosed in WO 2007131582 A1 and WO 2008/009343A1.

Preferably, the said organic functional material is an electron transport or injection polymer comprising groups 2, which is preferably selected from groups comprising the low molecular weight ETMs or ElMs as described above.

Further preferred units from group 2, which have electron-injection or electron-transport properties, are, for example, pyridine, pyrimidine, pyridazine, pyrazine, oxadiazole, quinoline, quinoxaline and phenazine derivatives, but also triarylboranes and further O, S or N containing heterocycles having a low LUMO. These units in the polymer preferably result in an LUMO of less than 2.7 eV (against vacuum level), particularly preferably less than 2.8 eV.

Preferably, the said organic functional material is a polymer comprising units from group 3 in which structures which increase the hole mobility and the electron mobility (i.e. units from groups 1 and 2) are bonded directly to one another. Some of these units may serve as emitters and shift the emission colour into the green, yellow or red. Their use is thus suitable, for example, for the production of other emission colours or a broad-band emission from originally blue-emitting polymers.

Preferably, the said organic functional material is a polymer comprising units of group 4, which is preferably selected from the groups comprising phosphorescent emitter, particularly emissive metal complexes as described above. Particular preference is given here to corresponding structural units which contain elements from groups 8 to 10 (Ru, Os, Rh, Ir, Pd, Pt).

Preferably, the said organic functional material is a polymeric triple matrix comprising units of group 5, which can improve the transition from the singlet state to the triplet state and which, employed in support of the structural elements from group 4, improve the phosphorescence prop¬erties of these structural elements. Suitable for this purpose are, in particular, carbazole and bridged carbazole dimer units, as described in DE 10304819 A1 and DE 10328627 A1. Also suitable for this purpose are ketones, phosphine oxides, sulfoxides, sulfones, silane derivatives and similar compounds, as described in DE 10349033 A1. Further preferred structure units can be selected from groups comprising the low molecular weight phosphorescent matrices as described above.

Preferably, the said organic functional material is a polymer comprising units of group 6, which influence the morphology and/or emission colour of the polymers, are, besides those mentioned above, those which have at least one further aromatic or another conjugated structure which do not fall under the above-mentioned groups, i.e. which have only little effect on the charge-carrier mobilities, which are not organometallic complexes or which have no influence on the singlet-triplet transition. Structural elements of this type may influence the morphology and/or emission colour of the resultant polymers. Depending on the unit, they can therefore also be employed as emitters. Preference is given here, in the case of fluorescent OLEDs, to aromatic structures having 6 to 40 C atoms or also tolan, stilbene or bisstyrylarylene derivatives, each of which may be substituted by one or more radicals R1. Particular preference is given here to the incorporation of 1,4-phenylene, 1,4-naphthylene, 1,4- or 9,10-anthrylene, 1,6-, 2,7- or 4,9-pyrenylene, 3,9- or 3,10-perylenylene, 4,4'-biphenylylene, 4,4"-terphenylylene, 4,4' bi 1,1'-naphthylylene, 4,4'-tolanylene, 4,4'-stilbenylene or 4,4"-bisstyrylarylene derivatives.

Preferably, the said organic functional material is a polymer comprising units of group 7 which contain aromatic structures having 6 to 40 C atoms which are typically used as polymer backbone. These are, for example, 4,5-dihydropyrene derivatives, 4,5,9,10-tetrahydropyrene derivatives, fluorene derivatives as disclosed for example in US 5962631, WO 2006/052457 A2 and WO 2006/118345A1, 9,9'-spirobifluorene de¬rivatives as disclosed for example in WO 2003/020790 A1, 9,10-phenanthrene derivatives as disclosed, for example, in WO 2005/104264 A1, 9,10-dihydrophenanthrene derivatives as disclosed for example in WO 2005/014689 A2, 5,7-dihydrodibenzooxepine derivatives and cis- and trans-indenofluorene derivatives as disclosed for example in WO 2004041901 A1, WO 2004113412 A2 and, binaphthylene derivatives as disclosed for example in WO 2006/063852 A1, and further units as disclosed for example in WO 2005/056633A1, EP 1344788A1 and WO 2007/043495A1, WO 2005/033174 A1, WO 2003/099901A1 and DE 102006003710.3.

Further preferred structural elements from group 7 are selected from fluorene derivatives, as disclosed for example in US 5,962,631, WO 2006/052457 A2 and WO 2006/118345 A1, spiro-bifluorene derivatives as disclosed for example in WO 2003/020790 A1, benzofluorene, dibenzofluorene, benzothiophene, dibenzofluorene and their derivatives as disclosed for example in WO 2005/056633A1, EP 1344788A1 and WO 2007/043495A1

Very preferred structural elements of group 7 are those of Formula 67: 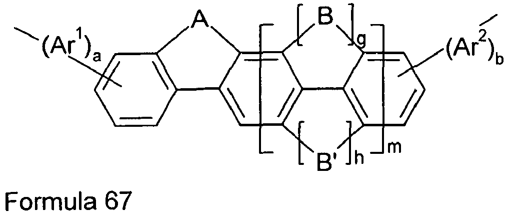 wherein
A, B and B' are independently of each other, and in case of multiple occurrence independently of one another, a divalent group, preferably selected from -CR¹R²-, -NR¹-, -PR¹-, -O-, -S-, -SO-, -SO₂-, -CO-, -CS-,-CSe-, -P(=O)R¹-, -P(=S)R¹- and -SiR¹R²-,
R¹ and R² are independently of each other identical or different groups selected from H, halogen, -CN, -NC, -NCO, -NCS, -OCN, -SCN, - C(=O)NR⁰R⁰⁰, -C(=O)X, -C(=O)R⁰, -NH₂, -NR⁰R⁰⁰, -SH, -SR⁰, -SO₃H,-SO₂R⁰, -OH, -NO₂, -CF₃, -SF₅, optionally substituted silyl, or carbyl or hydrocarbyl with 1 to 40 C atoms that is optionally substituted and optionally comprises one or more hetero atoms, and optionally the groups R¹ and R² form a spiro group with the fluorene moiety to which they are attached,
X is halogen,
R⁰ and R⁰⁰ are independently of each other H or an optionally substituted carbyl or hydrocarbyl group optionally comprising one or more hetero atoms,
each g is independently 0 or 1 and each corresponding h in the same subunit is the other of 0 or 1,
m is an integer ≥ 1
Ar¹ and Ar² are independently of each other mono- or polynuclear aryl or heteroraryl that is optionally substituted and optionally fused to the 7,8-positions or 8,9-positions of the indenofluorene group,
a and b are independently of each other 0 or 1.

If the groups R¹ and R² form a spiro group with the fluorene group to which they are attached, it is preferably spirobifluorene.

The groups of Formula 67 are preferably selected from the following Formulae 68 to 72: 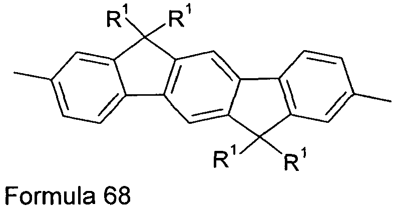 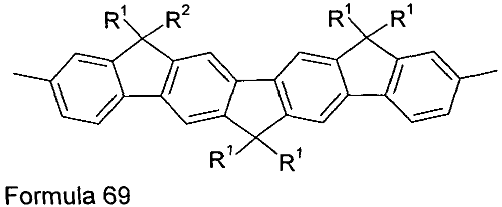 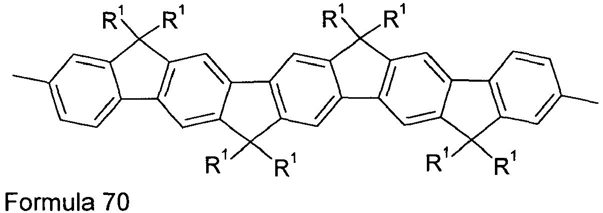 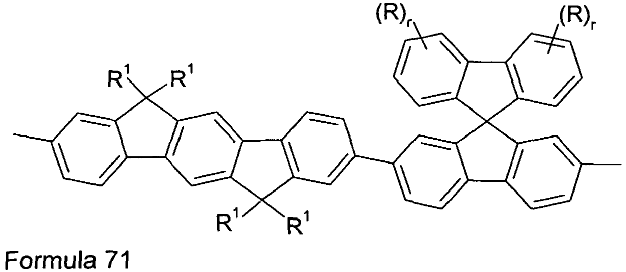 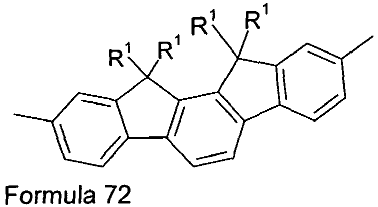 wherein R¹ is as defined in Formula 67, r is 0, 1, 2, 3 or 4, and R has one of the meanings of R¹.

R is preferably F, Cl, Br, I, -CN, -NO₂, -NCO, -NCS, -OCN, -SCN,-C(=O)NR⁰R⁰⁰, -C(=O)X⁰, -C(=O)R⁰, -NR⁰R⁰⁰, optionally substituted silyl, aryl or heteroaryl with 4 to 40, preferably 6 to 20 C atoms, or straight chain, branched or cyclic alkyl, alkoxy, alkylcarbonyl, alkoxycarbonyl, alkylcarbonlyoxy or alkoxycarbonyloxy with 1 to 20, preferably 1 to 12 C atoms, wherein one or more H atoms are optionally replaced by F or CI, and wherein R⁰, R⁰⁰ and X⁰ are as defined above.

Particularly preferred groups of Formula 67 are selected from the following Formulae 73 to 76: 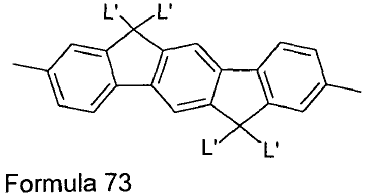 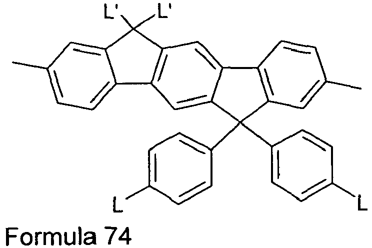 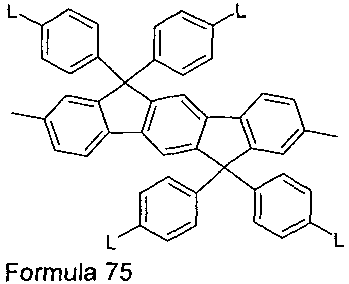 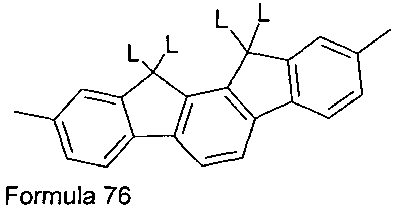 wherein
L is H, halogen or optionally fluorinated, linear or branched alkyl or alkoxy with 1 to 12 C atoms, and is preferably H, F, methyl, i-propyl, t-butyl, n-pentoxy, or trifluoromethyl, and
L' is optionally fluorinated, linear or branched alkyl or alkoxy with 1 to 12 C atoms, and is preferably n-octyl or n-octyloxy.

Preferably, the said organic functional material is a polymer comprising group 8, which can be selected from the groups comprising the dye materials as described above. The conjugated polymers suitable for organic solar cells, as summarized for example by F.C. Krebs, in Solar Energy Materials and Solar Cells, Vol91, 953 (2007), can also be used as the said organic functional material in the present invention.

Preference is given to polymers suitable for use in the invention which simultaneously comprise one or more units selected from groups 1 to 8. It may likewise be preferred for more than one structural unit from a group to be present simultaneously.

Preference is given to polymers suitable for use in the invention which, besides structural units of an emitter, also comprise at least one structural unit from the above-mentioned groups. At least two structural units are particularly preferably from different classes of those mentioned above.

The proportion of the different classes of groups, if present in the polymer, is preferably in each case at least 5 mol%, particularly preferably in each case at least 10 mol%. In particular, one of these structural units is selected from the group of hole-conducting units and the other group is an emitting unit, where these two functions (hole conduction and emission) may also be taken on by the same unit.

However, a smaller proportion of the emitting units, in particular green- and red-emitting units, may also be preferred, for example for the synthesis of white-emitting copolymers. The way in which white-emitting copolymers can be synthesised is described in detail in DE 10343606 A1.

In order to ensure adequate solubility, it is preferred for on average at least 2 non-aromatic C atoms to be present in the substituents per recurring unit. Preference is given here to at least 4 and particularly preferably at least 8 C atoms. In addition, individual C atoms of these may be replaced by O or S. However, it is entirely possible for this to mean that a certain proportion of recurring units does not carry any further non-aromatic substituents.
In order to avoid impairing the morphology of the film, it is preferred to have no long-chain substituents having more than 12 C atoms in a linear chain, particularly preferably none having more than 8 C atoms and in particular none having more than 6 C atoms.

The polymer used as organic functional material in the invention may be statistical or random copolymers, alternating or regioregular copolymers, block copolymers or combinations thereof.

In another preferred embodiment, the said polymer is a side-chain non-conjugated polymer, which is especially important for phosphorescent OLEDs based on polymer. In general, such phosphorescent polymer is obtained by means of radical copolymerization of vinyl compounds, and comprises at least one phosphorescent emitter and at least one charge transport unit on side chain, as disclosed in US 7250226 B2. Further examples for such phosphorescent polymer are disclosed for example in JP 2007/211243 A2, JP 2007/197574 A2, US 7250226B2, JP 2007/059939A.

In a further preferred embodiment, the said polymer is a main-chain non-conjugated polymer, where the backbone units are connected by spacer on main-chain. Like side-chain non-conjugated polymer, main-chain non-conjugated polymers give also a high triplet level. An example for triplet OLEDs based on main-chain non-conjugated polymers is disclosed in DE 102009023154.4.

In a further embodiment, the said polymer can also be a non-conjugated polymer for fluorescent OLEDs. Preferred singlet non-conjugated polymers are, for example, side-chain polymers with antracenenes, benzanthrecenes and their derivates in the side-chain, as disclosed in JP 2005/108556, JP 2005/285661, JP 2003/338375 etc..

The said polymers can also act as ETM or HTM, preferably the polymer is a non-conjugated polymer.

Devices according to the present invention may also comprise additional layer which were not deposited by using a formulation, i.e. a emulsion or dispersion according to this invention. The additional layer may be deposited by a technique from solution or by vapour deposition. Hereby the specific method employed depends on the characteristics of the material used and a person skilled in the art has no problem to select the appropriate technique. The material which is deposited can be any material used in the field of electronic and opto-electronic multilayer structures. In particular the material may be any material described herein. Furthermore, the materials may be selected from organic and inorganic functional materials as outlined below.

Inorganic compounds, such as p type Si and p type SiC, and inorganic oxides, e.g., vanadium oxide (VOₓ), molybdenum oxide (MoOₓ) or nickel oxide (NiOₓ) can also be used as HIM.

Electron injection layers (EILs) are often constructed from an insulator and semiconductor.

Preferred alcali metal chalcogenides for EILs are Li₂O, LiO, Na₂S, Na₂Se, NaO, K₂O, Cs₂O.

Preferred alkaline-earth metal chalcogenides for EILs are CaO, BaO, SrO, BeO, BaS, CaSe.

Preferred halides of alkali metals for EILs are LiF, NaF, KF, CsF, LiCI, KCI, NaCl.

Preferred halides of alkaline-earth metals for EILs are CaF₂, BaF₂, SrF₂, MgF₂, BeF₂.

It is likewise possible to employ alkali metal complexes, alkaline-earth metal complexes, rare-earth metals (Sc, Y, Ce, Th, Yb), rare-earth metal complexes, rare-earth metal compounds (preferably YbF₃, ScF₃, TbF₃) or the like.

The structure of EILs is described, for example, in US 5608287, US 5776622, US 5776623, US 6137223, US 6140763, US 6914269.

An electron-transport layer may consist of an intrinsic material or comprise a dopant. Alq₃ (EP 278757 B1) and Liq (EP 0569827 A2) are examples of intrinsic layers. 4,7-diphenyl-1,10-phenanthroline (Bphen):Li 1:1 (US 2003/02309890) and rubrene/LiF are examples of doped layers.

In addition to the materials mentioned above, an organic electroluminescent device according to the present invention may comprise at least one anode, at least one cathode and one or more substrates.

Preferred materials for the anode are metal oxides selected from, but not limited to, indium tin oxide (ITO), indium zinc oxide (IZO), tin oxide (SnO), ZnO, InO, aluminium-zinc-oxide (AlZnO), and other metal oxides such as Al- and In-zinc oxide doped with zinc oxide, magnesium-indium-oxide, and nickel-tungsten-oxide. Metal nitrides such as galliumnitrides and metal selenides such as zinc-selenide and metal-sulfides such as zinc-sulfide can also be used. Further materials that can be used for anodes are electrically conducting polymers, e.g. polythiophenes and polypyrroles.

The anode can be transparent, opaque, or reflective. The anode can also adopt an intermediate state, e.g. both being partially reflective and partially transparent.

If the anode is not or only partially transparent further conducting materials can be used. Preferred materials for non transparent or partially transparent anodes are selected from, but not limited to, Au, Ir, Mo, Pd, Pt, Cu, Ag, Sn, C, Al, V, Fe, Co, Ni, W, and mixtures thereof. The conducting materials can also be mixed with further conducting materials as described above, e.g. In-Cu.

The anode is preferably transparent and a particularly preferred material for the anode is ITO. In the case of a bottom-emitting device glass or plastic is preferably coated with ITO. In the case of a top-emitting device the anode comprises preferably a reflecting material. Further materials can be used for anodes, which are known to the person skilled in the art.

A flexible and transparent combination of substrate and anode is described in US 5844363 B2 and US 6602540 B2, for instance.

The cathode can be transparent, opaque, or reflective. The cathode is selected from a metal or an alloy with a low work function. Preferably metals, alloys, or conducting compounds or materials with a work function of less than 4.0 eV are used. Particularly preferred cathodes are selected from, but not limited to, Ba, Ca, Sr, Yb, Ga, Cd, Si, Ta, Sb, Zn, Mg, Al, In, Li, Na, Cs, Ag, mixtures of two or more elements such as alloys comprising Mg/AI or Al/Li or Al/Sc/Li or Mg/Ag or metal oxides such as ITO or IZO.

Further preferred materials for cathodes, used to form a thin dielectric layer, are selected from a metal which is mixed with LiF, Li2O, BaF₂, MgO, or NaF. A typical combination is LiF/Al.

An Mg/AI cathode with ITO layer on top is described in US 5703436, US 5707745, US 6548956 B2, US 6576134 B2. An Mg/Ag alloy is described in US 4885221.

The substrate may be rigid or flexible. It may be transparent, translucent, opaque or reflective. The materials used can be glass, plastic, ceramic or metal foils, where plastic and metal foils are preferably used for flexible substrates. However, semiconductor materials, such as, for example, silicone wafers or printed circuit board (PCB) materials, can also be employed in order to simplify the generation of conductor tracks. Other substrates can also be employed.

The glass used can be, for example, soda-lime glass, Ba- or Sr-containing glass, lead glass, aluminium silicate glass, borosilicate glass, Ba borosilicate glass or quartz.

Plastic plates can consist, for example, of polycarbonate resin, acrylic resin, vinyl chloride resin, polyethylene terephthalate resin, polyimide resin, polyester resin, epoxy resin, phenolic resin, silicone resin, fluorine resin, polyether sulfide resin or polysulfone resin.

For transparent films, use is made, for example, of polyethylene, ethylene-vinyl acetate copolymers, ethylene-vinyl alcohol copolymers, polypropylene, polystyrene, polymethyl methacrylate, PVC, polyvinyl alcohol, polyvinylbutyral, nylon, polyether ether ketone, polysulfone, polyether sulfone, tetrafluoroethylene-perfluoroalkyl vinyl ether copolymers, polyvinyl fluoride, tetrafluoroethylene-ethylene copolymers, tetrafluoroethylene-hexafluoropropylene copolymers, polychloro-trifluoroethylene, polyvinylidene fluoride, polyester, polycarbonate, polyurethanes, polyimide or polyether imide.

The substrate is provided with a hydrophobic layer. The substrates are preferably transparent.

Other materials than those mentioned here can also be used. Suitable materials are known to the person skilled in the art.

The present invention refers to a formulation comprising one continuous phase and one discontinuous phase, wherein at least one of the continuous phase comprises at least one first functional material and wherein at least one of the discontinuous phase comprises at least one second functional material, and wherein the first and second functional material(s) is (are) independently from each other selected from hole injection materials (HIM), hole transport materials (HTM), hole blocking materials (HBM), electron injection materials (EIM), electron transport materials (ETM), electron blocking materials (EBM), exciton blocking materials (ExBM), host materials, emitter materials, metal complexes, and dyes, and wherein the formulation comprises at least one solvent and at least one of the continuous phases comprises at least one host material selected from anthracenes, benzanthracenes, indenofluorenes, fluorenes, spirobifluorenes, phenanthrenes, dehydrophenanthrenes, thiophenes, triazines, imidazole, ketones, carbazoles, triarylamines, and derivatives thereof.

Particularly preferred is a formulation with preferably 3, particularly preferably 2, and very particularly preferably 1 continuous phase comprising preferably 3, particularly preferably 2, and very particularly preferably 1 host material(s).

Preference is given to a formulation, characterized in that at least one of the continuous phases comprises at least one electron transport material selected from imidazoles, pyridines, pyrimidines, pyridazines, pyrazines, oxadiazoles, chinolines, chinoxalines, anthracenes, benzanthracenes, pyrenes, perylenes, benzimidazoles, triazines, ketones, phosphinoxides, phenazines, phenanthrolines, triarylboranes and derivatives thereof.

Particularly preferred is a formulation with preferably 3, particularly preferably 2, and very particularly preferably 1 continuous phase comprising preferably 3, particularly preferably 2, and very particularly preferably 1 ETMs.

The ETM can be any ETM known to a skilled person. Preference is given to ETMs which are described elsewhere within this invention. Particular preference is given to ETMs selected from imidazoles, pyridines, pyrimidines, pyridazines, pyrazines, oxadiazoles, chinolines, chinoxalines, anthracenes, benzanthracenes, pyrenes, perylenes, benzimidazoles, triazines, ketones, phosphinoxides, phenazines, phenanthrolines, and triarylboranes.

Another preferred subject of the present invention relates to a formulation, characterized in that at least one of the continuous phases comprises at least one hole transport material selected from amines, triarylamines, thiophenes, carbazoles, phthalocyanines, porphyrines and derivatives thereof.

Particularly preferred is a formulation with preferably 3, particularly preferably 2, and very particularly preferably 1 continuous phase comprising preferably 3, particularly preferably 2, and very particularly preferably 1 HTMs.

The HTM can be any HTM known to a skilled person. Preference is given to HTMs which are described elsewhere within this invention. Particular preference is given to HTMs selected from amines, triarylamines, thiophenes, carbazoles, phthalocyanines, and porphyrines.

Preference is given to a formulation, characterized in that at least one of the continuous phases comprises at least one emitter material selected from fluorescent emitter materials and phosphorescent emitter materials. Particularly preferred is a formulation with preferably 3, particularly preferably 2, and very particularly preferably 1 continuous phase comprising preferably 3, particularly preferably 2, and very particularly preferably 1 emitter materials.

The emitter material can be any emitter material known to a skilled person. Preference is given to emitter materials which are described elsewhere within this invention.

A formulation, characterized in that at least one of the discontinuous phases comprises at least one emitter material is also subject of the present invention.

Preferably 3, particularly preferably 2 and very particularly preferably 1 of the discontinuous phases comprise preferably 3, particularly preferably 2, and very particularly preferably 1 emitter material.

In another subject of the present invention the formulation is characterized in that at least one of the discontinuous phases comprises at least one emitter selected from fluorescent emitter materials and phosphorescent emitter materials. Both the fluorescent emitter material and the phosphorescent emitter materials can be any emitter material known to a skilled person. Preference is given to emitter materials which are described elsewhere within this invention.

In a further preferred embodiment of the present invention the formulation is characterized in that at least one of the discontinuous phases comprises two fluorescent emitter materials.

In another preferred embodiment of the present invention the formulation is characterized in that at least one of the discontinuous phases comprise one fluorescent emitter material.

In another particularly preferably embodiment of the present invention, the formulation preferably 3, particularly preferably 2, and very particularly preferably 1 of the discontinuous phases comprise preferably 3, particularly preferably 2, and very particularly preferably 1 fluorescent emitter materials.

Preference is given to a formulation, characterized in that at least one of the continuous phases comprises at least one host material selected from ketones, carbazoles, triaryamines, indenofluorenes, fluorenes, spirobifluorenes, phenanthrenes, dehydrophenanthrenes, thiophenes, triazines, imidazoles and derivatives thereof, and in that at least one of the discontinuous phase comprises at least one phosphorescent emitter material.

In a further preferred embodiment of the present invention the formulation is characterized in that at least one of the discontinuous phases comprises two phosphorescent emitter materials.

In another preferred embodiment of the present invention the formulation is characterized in that at least one of the discontinuous phases comprise one phosphorescent emitter material.

In another particularly preferably embodiment of the present invention, the formulation preferably 3, particularly preferably 2, and very particularly preferably 1 of the discontinuous phases comprise preferably 3, particularly preferably 2, and very particularly preferably 1 phosphorescent emitter materials.

The formulations of the present invention can also comprise at least one metal complex in at least one of the discontinuous phases.

The metal complexes are organo metallic complexes. Any metal complex suitable for the use in opto-electronic devices and known to the one skilled in the art can be employed. Preference is given to the metal complexes as described elsewhere within the present invention. Particular preference is given to metal complexes comprising metals selected from transition metals, rare earths, lanthanides and actinides. Very particular preference is given to metal complexes comprising metals selected from Ir, Ru, Os, Eu, Au, Pt, Cu, Zn, Mo, W, Rh, Pd, and Ag.

Preferably 3, particularly preferably 2 and very particularly preferably 1 of the discontinuous phases comprise preferably 3, particularly preferably 2 and very particularly preferably 1 metal complexes.

HTMs can also be in the discontinuous phases of the formulations according to the present invention. Thus, in another embodiment of the present invention the formulation is characterized in that at least one of the discontinuous phases comprises at least one hole transport material.

Preferably 3, particularly preferably 2 and very particularly preferably 1 of the discontinuous phases comprise preferably 3, particularly preferably 2 and very particularly preferably 1 HTMs. Any HTM can be selected for this purpose as outlined elsewhere within the present invention.

In another embodiment of the present invention the formulation is characterized in that at least one discontinuous phase comprises at least one dye.

Preferably 3, particularly preferably 2 and very particularly preferably 1 of the discontinuous phases comprise preferably 3, particularly preferably 2 and very particularly preferably 1 dyes. Any dyes suitable for the use in opto-electronic devices and known to the skilled person can be selected for this purpose as outlined elsewhere within the present invention.

Preference is given to dyes selected from perylenes, ruthenium dyes, phthalocyanines, azo compounds, perylene diimides, porphyrines, squaraine compounds, and derivatives thereof.

Further preference is given to dyes selected from perylenes, ruthenium dyes, phthalocyanines, azo compounds, perylene diimides, porphyrines, and squaraine compounds.

A further preferred functional material is an electron acceptor, preferably selected from fullerenes, for example C₆₀, carbon nanotubes, graphene isomers and derivatives thereof. Preferably for photovoltaic application, the said dye and said further organic functional material form a type II energy offset structure, with an energy offset larger than 0.4 eV, preferably larger than 0.5 eV and particularly preferably larger than 0.6 eV.

Thus, the formulations comprising at least one fullerene or its derivatives, wherein preferably at least one of the discontinuous phases comprises the said fullerene are also subject of the present invention. Preferably the fullerenes are selected from C₆₀, C₇₀, C₇₆, C₈₀, C₈₆, C₉₀, and C₉₄, isomers and derivatives thereof. C60 fullerene, its isomers and derivatives are particularly preferred.

Further preferred fullerenes suitable for the present invention are selected from the group consisting of carbon allotropes, molecules composed entirely of carbon, in the form of a hollow sphere, ellipsoid, tube, or plane. Spherical fullerenes are also called buckyballs, and cylindrical ones are called carbon nanotubes or buckytubes. Graphene is an example of a planar fullerene sheet.

Preferably 3, particularly preferably 2 and very particularly preferably 1 of the discontinuous phases comprise preferably 3, particularly preferably 2 and very particularly preferably 1 fullerenes.

In another embodiment of the present invention the first and/or second functional material can be selected, in addition to the materials defined above, from quantum dots. Preferably the formulation according to the present invention comprises 1 to 100, particularly preferably 1 to 50, and very particularly preferably 1 to 10 quantum dots.

Preference is given to formulations according to the present invention comprising 3, particularly preferably 2, and very particularly preferably 1 quantum dot(s).

The quantum dot(s) can be located both in the discontinuous phase and/or in the continuous phase.

In a preferred embodiment the formulation comprises one continuous phase and one discontinuous phase, characterized in that the formulation comprises at least one, preferably 3, particularly preferably 2, and very particularly preferably 1 first functional material(s) and at least one, preferably 3, particularly preferably 2, and very particularly preferably 1 second functional material(s) and at least one, preferably 3, particularly preferably 2, and very particularly preferably 1 quantum dot(s).

It is further preferred, that the quantum dot(s) is(are) located in the same phase as one or more emitter materials. In particular, the quantum dots(s) are preferably located in the same phase as one or more fluorescent emitter materials, which may be first or second functional materials.

It is also preferred that the quantum dots(s) are located in the same phase as one or more phosphorescent emitter materials, which may be first or second functional materials.

However, in certain cases it is desirable to have emitter(s) and quantum dot(s) separated in different phases.

Quantum dots represent another class of emissive material. They are also called mono-dispersive nanocrystal as described below. The advantages of quantum dot are: 1) theoretical internal quantum efficiency as high as 100%, compared to 25% of the singlet organic emitter; 2) soluble in common organic solvents; 3) emission wavelength can be easily tuned by the core size; 4) narrow emission spectrum; 5) intrinsic stability in inorganic materials.

The first mono-dispersive nanocrystals including a semiconducting material, also referred to herein as quantum dots or QDs, were based on CdE (E=S, Se, Te) and were produced using the so called TOPO (trioctyl phosphine oxide) method by Bawendi and later modified by Katari et al. A review on synthesis of QDs is given by Murray, Norris and Bawendi, "Synthesis and characterization of nearly monodisperse CdE (E = sulfur, selen, tellurium) semiconductor nanocrystallites", J. Am. Chem. Soc. 115[19], 8706-8715, 1993. The mostly-reported caps of quantum dots are based on trioctylphosphine oxide (TOPO) or trioctylphosphine (TOP), which are supposed to have electron transporting properties.

Quantum dots can easily be produced and have a narrow emission spectrum in contrast to organic fluorescent or phosphorescent compounds. They can be tailored in terms of size which determines the quantum dot's emission maximum. High photoluminescent efficiency can also be obtained with quantum dots. Furthermore their emission intensity can be tailored by their concentration employed. Moreover, quantum dots are soluble in many solvents or can easily be made soluble in common organic solvents, allowing versatile processing methods, particularly printing methods such as screen printing, off-set printing, and ink jet printing.

In general, a quantum dot is a semiconductor whose excitons are confined in all three spatial dimensions. As a result, they have properties that are between those of bulk semiconductors and those of discrete molecules. There are several ways to prepare quantum dot structures, for example by chemical methods or by ion implantation, or in nanodevices made by state-of-the-art lithographic techniques.

The quatuim dots of the present invention refer to colloidal semiconductor nanocrystals, also known as colloidal quantum dots, or nanodots or nanocrystals, which are produced by chemical methods.

The term quantum dots (QDs) refers to nanocrystals that are substantially mono-disperive in size. A QD has at least one region or characteristic dimension with a dimension of less than about 500 nm, and down to on the order of less than about 1 nm. The term mono-dispersive means the size distribution is within +-10% of the stated value, for example a mono-dispersive nanocrystals of 100 nm in diameter encompasses a range of sizes from 90 nm or larger to 110 nm or smaller.

The concentration range of quantum dot(s) in the formulation can be chosen from: between 0.01 and 20 wt%, between 0.05 and 10 wt%, and between 0.1 and 5 wt%, referring to the total weight of the formulation.

The first mono-dispersive colloidal quantum dots including a semiconducting material were based on CdE (E = S, Se, Te) and were produced using the so called TOPO (trioctyl phosphine oxide) method by Bawendi and later modified by Katari et al. A review on synthesis of QDs is given by Murray, Norris and Bawendi, "Synthesis and characterization of nearly monodisperse CdE (E = sulfur, selen, tellurium) semiconductor nanocrystallites", J. Am. Chem. Soc. 115[19], 8706-8715, 1993.

While any method known to the skilled person can be used to create QDs, preferably a solution-phase colloidal method for controlled growth of inorganic QDs is used. The said colloidal methods are disclosed, e.g., by Alivisatos, A. P., "Semiconductor clusters, nanocrystals, and quantum dots," Science 271:933 (1996); X. Peng, M. Schlamp, A. Kadavanich, A. P. Alivisatos, "Epitaxial growth of highly luminescent CdSe/CdS Core/Shell nanocrystals with photostability and electronic accessibility," J. Am. Chem. Soc. 30:7019-7029 (1997); and C. B. Murray, D. J. Norris, M. G. Bawendi, "Synthesis and characterization of nearly monodisperse CdE (E=sulfur, selenium, tellurium) semiconductor nanocrystallites," J. Am. Chem. Soc. 115:8706 (1993). These methods allow low cost processability without the need for clean rooms and expensive manufacturing equipment. In these methods, metal precursors that undergo pyrolysis at high temperature are rapidly injected into a hot solution of organic surfactant molecules. These precursors break apart at high temperatures and react to nucleate nanocrystals. After this initial nucleation phase, a growth phase begins by the addition of monomers to the growing crystal. Thus, crystalline nanoparticles are obtained in solution that has an organic surfactant molecule coating their surface.

In these methods, synthesis occurs as an initial nucleation event that takes place over seconds, followed by crystal growth at elevated temperature for several minutes. Parameters such as the temperature, types of surfactants present, precursor materials, and ratios of surfactants to monomers can be modified so as to change the nature and progress of the reaction. The temperature controls the structural phase of the nucleation event, rate of decomposition of precursors, and rate of growth. The organic surfactant molecules mediate both solubility and control of the nanocrystal shape. The ratio of surfactants to monomer, surfactants to each other, monomers to each other, and the individual concentrations of monomers strongly influence the kinetics of growth.

In these methods, synthesis occurs as an initial nucleation event that takes place over seconds, followed by crystal growth at elevated temperature for several minutes. Parameters such as the temperature, types of surfactants present, precursor materials, and ratios of surfactants to monomers can be modified so as to change the nature and progress of the reaction. The temperature controls the structural phase of the nucleation event, rate of decomposition of precursors, and rate of growth. The organic surfactant molecules mediate both solubility and control of the nanocrystal shape. The ratio of surfactants to monomer, surfactants to each other, monomers to each other, and the individual concentrations of monomers strongly influence the kinetics of growth.

Suitable semiconducting materials, which can be incoporated into QDs, are selected from elements of Group II- VI, such as CdSe, CdS, CdTe, ZnSe, ZnO, ZnS, ZnTe, HgS, HgSe, HgTe and alloys thereof such as CdZnSe; Group III-V, such as InAs, InP, GaAs, GaP, InN, GaN, InSb, GaSb, AlP, AlAs, AlSb and alloys such as InAsP, CdSeTe, ZnCdSe, InGaAs; Group IV-VI, such as PbSe, PbTe and PbS and alloys thereof; Group III-VI, such as InSe, InTe, InS, GaSe and alloys such as InGaSe, InSeS; Group IV semiconductors, such as Si and Ge alloys thereof, and combinations thereof in composite structures.

Further suitable semiconductor materials include those disclosed in U.S. patent application Ser. No. 10/796,832 and include any type of semiconductor, including group II-VI, group III-V, group IV-VI and group IV semiconductors. Suitable semiconductor materials include, but are not limited to, Si, Ge, Sn, Se, Te, B, C (including diamond), P, BN, BP, BAs, AIN, AlP, AlAs, AIS, AlSb, BaS, BaSe, BaTe, CaS, CaSe, CaTe, GaN, GaP, GaAs, GaSb, InN, InP, InAs, InSb, AIN, AlP, AlAs, AlSb, GaN, GaP, GaAs, GaSb, ZnO, ZnS, ZnSe, ZnTe, CdS, CdSe, CdTe, HgS, HgSe, HgTe, BeS, BeSe, BeTe, MgS, MgSe, GeS, GeSe, GeTe, SnS, SnSe, SnTe, PbO, PbS, PbSe, PbTe, CuF, CuCl, CuBr, Cul, Si₃N₄, Ge₃N₄, Al₂O₃, (Al, Ga, In)₂ (S, Se, Te)₃, and Al₂CO. Furthermore, further suitable semiconductor materials include combinations of the aforementioned semiconductors and/or combinations with core/shell, core multi-shell layered structures.

The present invention also relates to a method for the preparation of a formulation according to the present invention comprising the following steps:
(a) preparing a first solution comprising said at least one first functional material in at least one first solvent, and optionally comprising at least one surfactant;
(b) preparing a second solution comprising said at least one second functional material in at least one second solvent;
(c) mixing the first solution obtained in step (a) and the second solution obtained in step b) in a specific ratio;
(d) forming a formulation from the mixture obtained in step (c) by a physical method.

Preferably the formulation is obtained by applying a high shear force, whereby the preferred physical technique to be used in step (d) for this purpose is ultrasonication.

A preferred ratio is in the range of 3:1 to 15:1 in weight. One preferred first solvent is water and/or alcohol.

The suitable surfactant can be selected from the surfactants as described above. Preferably sodium dodecylsulfate (SDS) is used. The amount of surfactant(s) is preferably in the range from 0.1 to 20 wt%, particularly preferably from 0.2 to 10 wt%, and very particularly preferably from 0.5 to 5 wt%, based on the overall weight of the formulation.

The suitable second organic solvent can be selected from the organic solvents as described above. Preferably, the weight concentration of the functional materials in the second solution is from 0.5 to 10%, preferably 1 to 5%, particularly preferably 2 to 4%.

Preferably, the weight concentration of the organic functional materials in the first solution is from 0.5 to 10%, preferably 1 to 5%, particularly preferably 2 to 4%.
In a further embodiment of the present invention step d) is conducted by ultrasonic treatment or a high pressure homogenisator or a jet disperser, preferably by ultrasonic treatment.

Yet another embodiment not forming part of the present invention relates to a method for the preparation of a formulation which is an water-in-oil emulsion comprising similar steps as described above, wherein the first solution is an organic solvent comprising at least one first functional material with optionally a surfactant, and the second solution is a water and/or alcohol solution comprising at least one second functional material. Formulations according to the present invention can be used for the preparation of a layer and multilayer structure in order to establish a stack of functional materials, e.g. for the preparation of electronic or opto-electronic devices such as OLEDs. For further processing it is sometimes advantageous to remove the solvent(s) from one or more discontinuous phases before coating, which results in a formulation which is a dispersion comprising the continuous phase(s) comprising the first functional material(s) in solution and the discontinuous phase(s) comprising the organic functional material as solid nanoparticles in at least one of the discontinuous phase dispersed in the continuous phase(s).

Therefore, the present application also relates to a dispersion, characterized in that the dispersion comprises nanoparticles dispersed in a continuous phase formed by removing the solvent of the discontinuous phase of the emulsion according to the present disclosure. The nanodroplets of the emulsion according to the present disclosure are, thus, converted into a solid nanoparticles which are dispersed in the continuous phase(s) of the formulation. The term dispersion is used herein for a system comprising at least one liquid media (e.g. an aqueous or alcohol-based phase) and an organic phase suspended as solid particle, preferably as nanoparticles.

The present disclosure also relates to a dispersion comprising nanoparticles dispersed in the continuous phase(s) of the formulations according to the present invention, characterized in that the nanoparticles comprise at least one functional material and the continuous phase also comprise at least one functional material.

Preferably the nanoparticles comprise 3, particularly preferably 2, and very particularly preferably 1 organic functional material.

Any formulation according to the present invention can be either an emulsion or dispersion. Any of the emulsions according to the present disclosure can be converted into a dispersion.

The dispersion according to the present disclosure can be prepared from emulsions according to the present disclosure. Therefore, another subject of the present disclosure is a method for the preparation of a dispersion by removing the solvent of at least one discontinuous phase of the emulsion. Preferably the solvent is removed by evaporation. Particularly preferably evaporation of the solvent is facilitated or at least supported by heating. The emulsion according to the present disclosure may comprise one or more surfactants, which may be, at least in part, be removed, preferably by diafiltration, after the solvent(s) of the discontinuous phase is removed.

If a surfactant is present it can be removed up to 50%, preferably up to 60%, particularly preferably up to 70%, and very particularly preferably up to 80% of its original content.

Layer structures are crucial for various organic electronic or opto-electronic devices. The present disclosure further relates to a method for preparing a layer structure using orthogonal solvents by making use of the formulation, i.e. the emulsion and/or the dispersion, according to the present invention. The formulations according to the present invention can be used in various ways to prepare a layer structure. Preferably the layer structure is a multilayer structure.

The preferred ways are described as below:
The first method comprises the following steps:
   (a) prepare the first organic layer on a substrate;
   (b) prepare the second organic layer above the first organic layer by coating a formulation (i.e. emulsion or dispersion) according to the present invention;
   characterised in that the first organic layer is insoluble or has a limited solubility in the solvent in the continuous phase of the said emulsion or dispersion
In the said first method, the first layer can either be deposited by thermal evaporation or (preferably) be coated from solution, for example by spin-coating, ink-jet printing, screen printing, slot printing, nozzle printing, etc. In the step (b), it is essentially that the first organic layer is insoluble or has only a limited solubility in the solvent in the continuous phase of the said emulsion or dispersion, so that the first layer is still closed after coating the emulsion or the dispersion. Preferably, the maximal solubility of the first layer is less than 0.4 wt% at the working temperature in the solvent of the continuous phase of said emulsion or dispersion. And most preferably the first layer is insoluble in the solvent of the continuous phase of said emulsion or dispersion.

The second method comprises the following steps:
(a) prepare the first organic layer on a substrate by coating a formulation (i.e. emulsion or dispersion) according to the present invention;
(b) prepare the second organic layer above the first organic layer from a second solution;
characterised in that the first organic functional material in the first organic layer is insoluble or has a limited solubility in the solvent of the second solution.

In the said second method, both layers are coated from solution by a coating technique, which can be selected from spin-coating, or printing techniques such as ink-jet printing, screen printing, slot printing, nozzle printing, etc. In the step (b), it is essentially that the first organic layer has only a limited solubility in the solvent of the second solution, so that the first layer is still closed after coating the emulsion or the dispersion. Preferably, the maximal solubility of the first layer is less than 0.4wt% at the working temperature in the solvent of the continuous phase of said emulsion or dispersion. And most preferably the first layer is insoluble in the solvent of the second solution.

The third method comprises the following steps:
(a) prepare the first organic layer on a substrate by coating a formulation (i.e. emulsion or dispersion) according to the present invention;
(b) prepare the second organic layer above the first organic layer from a second or a second dispersion according to the present invention;
characterised in that the first organic functional material in the first organic layer is insoluble or has a limited solubility in the solvent of the continuous phase of the second emulsion or dispersion.

In the said third method, both layers are coated from solution by a technique selected from spin-coating, or printing techniques such as ink-jet printing, screen printing, slot printing, nozzle printing, etc. In the step (b), it is essentially that the first organic layer has only a limited solubility in the solvent in the continuous phase of the said emulsion or dispersion, so that the first layer is still closed after coating the emulsion or the dispersion. Preferably, the maximal solubility of the first layer is less than 0.4 wt% at the working temperature in the solvent of the continuous phase of said emulsion or dispersion. And most preferably the first layer is insoluble in the solvent of the continuous phase of said emulsion or dispersion.

In a very preferred embodiment, the methods as described above for preparing a multilayer structure use a dispersion as coating media.

In a further preferred embodiment of the present disclosure the method for the preparation of a multi layer structure as described above is characterized in that at least one additive is added to the dispersion. Preferably 3, particularly preferably 2, and very particularly preferably 1 additive is added to the dispersion. The preferred function of the additive is the modification of physical properties in order to facilitate the preparation of multi layer structures.

Particularly preferably the additive modifies the surface tension of the dispersion in order to enable film formation. A typical problem in context with the preparation of a multilayer structure using orthogonal solvents is the wetting of the solution or dispersion on the underneath layer. Therefore, it is necessary to modify the solution or dispersion, for example its surface tension, before its use. It can be achieved by adding additional additives, for example wetting agents, dispersing agents, hydrophobing agents, adhesive agents etc. Further suitable additive can be referred to for example WO 2003/019693 A2.

The important parameters for deposition techniques from solution or dispersion are for example viscosity, surface tension, concentration, molecular weight of the solution, and particle size of the dispersion, boiling point of solvent, etc.. Indeed, different deposition techniques demand different parameters. For the most widely used techniques, spin-coating and inkjet printing, they have some parameters in common; for example, they demand a viscosity of 4 to12 mPas, and surface tension < 40 mN/m, particles with a size of ≤ 1 µm, and boiling point of solvent from 70 to 190°C, though the optimal condition may be different from each other depending on the method and the substrate used.

It is important to adjust the above mentioned parameter of the solution or dispersion in a desired corridor. This can be achieved by adding different additives. However, the additive will be left in the film, which is not desired. Surprisingly, the physical parameters as described above can be appropriately modified by using a suitable co-solvent, which is miscible with the solvent of the solution or dispersion, but not necessary a solvent for the solute of the solution or the organic functional materials in the discontinuous phase of the dispersion. For coating water-based dispersion of the present invention on an organic layer, the suitable co-solvent should fulfil either 1) surface tension in range of 10 to 40 mPas or 2) a boiling point from 70 to 200°C, and a particularly suitable co-solvent should fulfil both conditions. A good example for the suitable co-solvent for the water-based dispersion of the present invention is iso-propanol (see working examples).

Therefore, a preferred additive is a co-solvent, particularly preferably an alcohol, and very particularly preferably iso-propanol.

In further another embodiment, the present disclosure relates to a coating method using the emulsion and/or dispersion as described above and below. It is desirable to generate small structures or patterns in modern microelectronics to reduce cost (more devices/unit area), and power consumption. Patterning of the layer of the disclosure may be carried out, for example, by photolithography, electron beam lithography, nano-imprint lithography (as reported for example in Science (96), 272, 85-87), or "Dip-Pen" Nanolithography (as reported in Science (99), 283, 661-663). For use as thin layers in electronic or opto-electronic devices the organic functional materials or an emulsion or dispersion according to the present invention may be deposited by any suitable method. Liquid coating of devices such as OLEDs is more desirable than vacuum deposition techniques. Solution deposition methods are especially preferred. Preferred deposition techniques include, without limitation, dip coating, spin coating, ink jet printing, letter-press printing, screen printing, doctor blade coating, roller printing, reverse-roller printing, offset lithography printing, flexographic printing, web printing, spray coating, brush coating or pad printing, slot-die coating. Ink-jet printing is particularly preferred as it allows high resolution displays to be prepared.

Selected emulsions and /or dispersions according to the present disclosure may be applied to prefabricated device substrates by ink jet printing or microdispensing. Preferably industrial piezoelectric print heads such as but not limited to those supplied by Aprion, Hitachi-Koki, InkJet Technology, On Target Technology, Picojet, Spectra, Trident, Xaar may be used to apply the organic functional material layer to a substrate. Additionally semi-industrial heads such as those manufactured by Brother, Epson, Konica, Seiko Instruments Toshiba TEC or single nozzle microdispensers such as those provided by Microdrop and Microfab may be used.

In order to be applied by ink jet printing or microdispensing, the emulsion and /or dispersion according to the present disclosure should be first prepared in a suitable solvent in the continuous phase. Solvents must fulfil the requirements stated above and must not have any detrimental effect on the chosen print head. In the case of water-based or other polar solvent-based emulsion, the use of such emulsions or dispersions are known in conjunction with desktop inkjet printers. For inverse emulsions and dispersion thereof, where the continuous phase is non-polar, solvents should have boiling points >100°C, preferably >140°C and more preferably >150°C in order to prevent operability problems caused by the solution drying out inside the print head. Apart from the solvents already disclosed herein, suitable solvents include substituted and non-substituted xylene derivatives, di-C1-2-alkyl formamide, substituted and non-substituted anisoles and other phenol-ether derivatives, substituted heterocycles such as substituted pyridines, pyrazines, pyrimidines, pyrrolidinones, substituted and non-substituted N,N-di-C1-2-alkylanilines and other fluorinated or chlorinated aromatics.

A preferred solvent for depositing an inverse emulsion and dispersion thereof according to the present disclosure by ink jet printing comprises a benzene derivative which has a benzene ring substituted by one or more substituents wherein the total number of carbon atoms among the one or more substituents is at least three. For example, the benzene derivative may be substituted with a propyl group or three methyl groups, in both cases there are three substituting carbon atoms in total. Such a solvent enables an ink jet fluid to be formed comprising the solvent with the polymer, which reduces or prevents clogging of the jets and separation of the components during spraying. The solvent(s) may include those selected from the following list of examples: dodecylbenzene, 1-methyl-4-tert-butylbenzene, terpineol limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer. The ink jet fluid (that is an emulsion according to present disclosure) preferably has a viscosity at 20°C of 1 to 100 mPa.s, more preferably 1 to 50 mPa.s and most preferably 1 to 30 mPa.s.

The layer of a device prepared according to the teaching of the present disclosure have, due to the particle-related structure of the nanoparticles in dispersions or nanodroplets in emulsions a particular structure. This particular nano-structure, in turn, tremendously determines the structure of the corresponding layer and the beneficial opto-electronic characteristics of the layer itself and of the device as a whole. The present disclosure relates also to layer and multilayer structures obtainable by the use of a formulation according to the present invention. The present disclosure also relates to devices comprising said layer. Preferably the devices are opto-electronic devices as outlined elsewhere in the present disclosure.

The present disclosure also relates to devices obtainable by the use of a formulation according to the present invention.

The emulsions and dispersions according to the present disclosure can be tailored in regards to their physical and chemical properties and may therefore be used in any kind of electronic device. The use of the emulsions and dispersions according the disclosure or the dispersion according to the disclosure obtained by a method according to the invention for the preparation of electronic and opto-electronic devices is also subject of the present disclosure.

Preferably the emulsions and dispersions according to the present disclosure may be used in opto-electronic devices, in which the absorption or emission of electromagnetic radiation preferably in the ultraviolet, visible or infrared part of the spectrum, plays a crucial role, such as light emitting devices, light sensors or light harvesting devices (e.g. photovoltaic cells).

Another subject of the present disclosure relates to the use of the methods for the preparation of layer structures according to this invention for the preparation of electronic and opto-electronic devices.

Preference is given to the use of emulsions and/or dispersions according to the present disclosure in electronic and opto-electronic devices selected from organic light emitting diodes (OLEDs), polymer light emitting diodes (PLEDs), fiber OLEDs, organic light emitting electrochemical cells (OLECs), organic field effect transistors (OFETs), thin film transistors (TFTs), organic solar cells (O-SCs), dye-sensitised solar cells (DSSCs), organic laser diodes (O-laser), organic integrated circuits (O-IC), radio frequency identification (RFID) tags, photodetectors, sensors, logic circuits, memory elements, capacitors, charge injection layers, Schottky diodes, planarising layers, antistatic films, conducting substrates or patterns, photoconductors, electrophotographic elements, organic light emitting transistors (OLETs), organic spintronic devices, and organic plasmon emitting devices (OPEDs).

The disclosure further relates to an electronic or opto-electronic device obtained by a method according to the invention. Preferably the device is selected from organic light emitting diodes (OLEDs), polymer light emitting diodes (PLEDs), fiber OLEDs, organic light emitting electrochemical cells (OLECs), organic field effect transistors (OFETs), thin film transistors (TFTs), organic solar cells (O-SCs), dye-sensitised solar cells (DSSCs), organic laser diodes (O-laser), organic integrated circuits (O-IC), radio frequency identification (RFID) tags, photodetectors, sensors, logic circuits, memory elements, capacitors, charge injection layers, Schottky diodes, planarising layers, antistatic films, conducting substrates or patterns, photoconductors, electrophotographic elements, organic light emitting transistors (OLETs), organic spintronic devices, and organic plasmon emitting devices (OPEDs). Particularly preferably the device is a OLED, and an O-SCs.

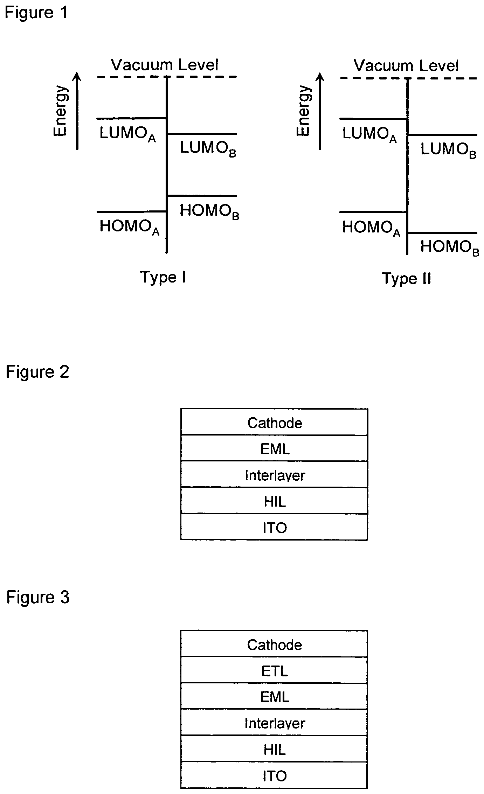

It is usually an advantage to have a plurality of organic functional materials within a device, either in the same layer or in two adjacent layers, forming a heterojunction either in between the layers or a bulk heterojunction in the layer (see Figure 1). Such heterojunctions can be classified into 2 classes: type I, in which the LUMO and HOMO levels of one material (material A) lie within the LUMO-HOMO energy gap of the second material (material B), as illustrated on the left hand side of Figure 1, and type II, in which the minimum energy difference between the highest HOMO state and the lowest LUMO state is between levels on different sides of the heterojunction, as illustrated on the right hand side of Figure 1. Electrons tend to occupy the energetically lowest LUMO level, whereas holes tend to occupy the energetically highest HOMO level. Thus, in a type I heterojunction electrons and holes are located on the same side of the junction and in a type II heterojunction both electrons and holes are located on different sides of the junction. However, because in organic functional materials, the exciton binding energy is usually assumed to be 0.5 eV or more, the band offset of type II is necessarily bigger than about 0.5 eV to ensure the efficient excition dissociation at the heterojunction, which is an important issue particularly for organic solar cells.

Preference is given to an OLED which is prepared by using at least one emulsion or dispersion according to the present disclosure, wherein said emulsion or dispersion comprises at least one organic functional material as outlined above.

A typical sequence of layers as found in an OLED and O-SC is, for example:
- optionally a first substrate,
- an anode layer,
- optionally a hole injection layer (HIL),
- optionally a hole transport layer (HTL) and/or an electron blocking layer (EBL),
- an active layer, which upon electrical or optical exciation, produces excitons,
- optionally an electron transport layer (ETL) and/or a hole blocking layer (HBL),
- optionally an electron injection layer (EIL),
- a cathode layer,
- optionally a second substrate.

The sequence of the given layer structure is exemplary. Other sequences are possible. Depending on the active layers in the above mentioned device, different opto-electronic devices will be obtained. In a first preferred embodiment, the active layer generates excitons upon electrical excitation through applying voltage between anode and cathode, and further emits light through radiative decay of the excitons. In general, this is called light emitting device. In another preferred embodiment, the active layer generates exciton through absorbing light, and further produces free charge carrier through exciton dissociation. In general, this is called photovoltaic or solar cell.

The term interlayer as used herein is defined as layer between the hole injection layer (or buffer layer) and the emissive layer in polymer light emitting diodes (PLEDs), being an electron blocking layer, as disclosed for example in WO 2004/084260 A2. The typical device structure of PLEDs with interlayer is shown in Figure 2. However one problem with this kind of device is that the interlayer is usually, at least in part, washed away upon coating the EML layer, which leads to a very thin layer. This process is not well-controlled in the prior art. It is highly desired to use ETL or HMB in PLEDs, as shown in Figure 3, in order to get better confinement of holes and exciton in the EML to achieve high efficiency and lifetime.

In another preferred embodiment, the electronic device of the disclosure is soluble system based OLEDs, particularly PLEDs as disclosed for example in WO 2004/084260 A2, which comprises the multilayer structure as follows: anode/HIUEMUCathode, wherein the double-layer HIUEML is made by using at leat one dispersion and one method for multilayer structure as described above.

The HIL is usually a transparent conductive polymer thin film comprising HIM. Preferred HIM are those mentioned above. The emissive materials may further comprise a blend or mixture of two or more different emitters, for example two emitters of different type and/or emitters that emit light of different colors. Thus, a device of the present disclosure may provide white light.

The device structure of the above mentioned further electronic device is clear to the skilled person in the art in the field. Nevertheless, for the sake of clarity, references are made to some detailed device structures.

Organic Plasmon emitting device is preferably referred to the device as reported by Koller et al., in Nature Photonics (2008), 2, 684-687. The OPED is very similar as OLED as described above, except that at least one of anode and cathode should be capable to couple surface Plasmon from the emissive layer. It is preferred here that an OPED is prepared by using an emulsion or dispersion and the methods described herein.

One preferred organic spintronic device is a spin-valve device, as reported, e.g., by Z.H. Xiong et al., in Nature 2004, Vol. 427, 821, comprising two ferromagnetic electrodes and an organic layer between the two ferromagnetic electrodes. The ferromagnetic electrode is composed of Co, Ni, Fe, or alloys thereof, or ReMnO₃ or CrO₂, wherein Re is rare earth element. It is preferred that at least one of the organic layer is coated from an emulsion or dispersion according the present disclosure.

Organic light emitting electrochemical cells (OLECs) comprise two electrodes, and a mixture or blends of electrolyte and fluorescent species in between, as firstly reported by Pei & Heeger in Science (1995), 269, 1086-1088. I It is preferred here that an OLEC is prepared by using an emulsion or dispersion and the methods described above and below.

Dye-sensitized solar cells (DSSCs) comprise, in the sequence, an electrode/dye-sensitized TiO₂ porous thin film/electrolyte/counter electrode, as firstly reported by O'Regan & Grätzel in Nature (1991), 353, 737-740. The liquid electrolyte can be replaced by a solid hole transport layer, as reported in Nature (1998), 395, 583-585.

The structure of layer obtained via a method for the preparation of a devices as described herein clearly distinguishes from other layers. The structure of these layers results in beneficial opto-electronic characteristics of the layer and device. Therefore, the present disclosure also relates to devices comprising nanoparticles according to the present disclosure.

The present disclosure also relates to devices comprising a layer obtainable by the use of a formulation according to the present invention.

The formulations (dispersions, emulsions) of the present invention, devices comprising them and devices obtainable by using the said formulations can be used for any kind of light sources, which includes, but is not limited to, lightening and display applications. Light sources play also a crucial role in many therapeutic, cosmetic, prophylactic, and diagnostic applications. In some of these applications the function of light sources is solely directed to illuminate a display or the subject to be treated. In other cases the beneficial effect of light is exploited when human or animal subjects are treated. Thus, formulations, i.e. both emulsions and dispersions, according to the present invention can be used for the treatment, prophylaxis, and or diagnosis of therapeutic diseases and/or cosmetic conditions. This includes any kind of phototherapy, photodynamic therapy, and any combination of light therapy and therapies not using light such as drug therapies, commonly referred herein as to light therapy or light treatment. Many light treatments are directed to outer surfaces of the subject to be treated such as skin, wounds, mucosa, eye, hair, nail, nail beds, and gingival, and tongue, but light treatment can also be applied inside the subject in order to treat, e.g., the lungs, blood vessels, heart, breast, and other organs of the subject.

These diseases and/or conditions include, e.g., skin diseases, and skin-related conditions including skin-ageing, and cellulite, enlarged pores, oily skin, folliculitis, precancerous solar keratosis, skin lesion, aging, wrinkled and sun-damaged skin, crow's feet, skin ulcers (diabetic, pressure, venous stasis), acne rosacea lesions, cellulite; photomodulation of sebaceous oil glands and the surrounding tissues; reducing wrinkles, acne scars and acne bacteria, inflammation, pain, wounds, psychological and neurological related diseases and conditions, edema, Pagets disease, primary and metastatic tumors, connective tissue disease, manipulation of collagen, fibroblast, and fibroblast derived cell levels in mammalian tissue, illuminating retina, neoplastic, neovascular and hypertrophic diseases, inflammation and allergic reactions, perspiration, sweating and hyperhydrosis from eccrine (sweat) or apocrine glands, jaundice, vitiligo, ocular neovascular diseases, bulimia nervosa, herpes, seasonal affective disorders, mood, sleep disorders, skin cancer, crigler naijar, atopic dermatitis, diabetic skin ulcers, pressure ulcers, bladder infections, relief of muscular pains, pain, stiffness of joints, reduction of bacteria, disinfection, disinfection of liquids, disinfection of beverages such as water, disinfection of nutrition, gingivitis, whitening teeth, treatment of teeth and tissue in mouth, wound healing.

The said formulations, devices comprising them, and devices obtainable by the use of formulations according to the present invention comprise at least one organic electroluminescent compound which emits light in the range between 200 and 1000 nm, preferably between 300 and 1000 nm, particularly preferably between 300 and 950 nm, and very particularly preferably between 400 and 900 nm.

Other features of the invention will become apparent in the course of the following description of exemplary embodiments and drawings, which are given for illustration of the invention and are not intended to be limiting thereof.

### Brief Description of the Drawings

Figure 1: Orbital energy schema of Type I and Type II heterojunctions.
Figure 2: Typical layer structure of an OLED comprising cathode, EML (emissive layer), interlayer, HIL (hole injection layer), and ITO (anode).
Figure 3: Typical layer structure of an OLED comprising cathode, ETL (electron transporting layer), EML (emissive layer), interlayer, HIL (hole injection layer), and ITO (anode).
Figure 4: Absorption spectrum of SM3 overlapping with the PL (photoluminescence) spectrum of SM1, which are both singlet emitter. In addition, the PL spectrum of SM3 is shown.
Figure 5: Absorption spectra of the triplet emitter TEG1 and TER1 and PL of TEG1.

### Working Examples

### Example 1 (not forming part of the present invention)

### Materials

The following polymer IL1 can be synthesized by employing the Suszuki coupling. The reaction can be carried out according to synthetic methods well known to the person skilled in the art. The method is described, e.g., in WO 2003/048225.

Polymer IL1, used as interlayer, is the copolymer comprising the following monomers with mol% as indicated:

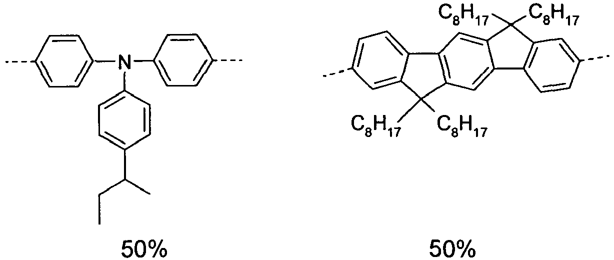

The molecular weight (MW) of the resulting polymer is distributed between 200.000 and 300.000 g/mol.

The light emitting Polymers LEP1 (poly(2,5-bis(3-sulfonatopropoxy)-1,4-phenylene, disodium salt-alt-1,4-phenylene)) and LEP2 (poly{[2,5-bis(2-(N,N-diethylamino)ethoxy)-1,4-phenylene]-alt 1,4-phenylene}) can be purchased from Sigma Aldrich. The polymers are water soluble, can also be used as host polymer for singlet blue and singlet green emitter, and have the following structures.

The following small molecules are used as functional materials.SM1 is a blue emitter, SM1 is a host material, SM3 is a singlet green emitter, TER1 is a triplet red emitter, TEG1 is a triplet green emitter, and HTM1 is a hole transport material. SM1 can be synthesized according to WO 2008/006449A1, SM2 according to JP 3148176 B2, SM3 according to the methods disclosed in WO 2008/006449 A1. All of these materials are well-soluble in toluene.

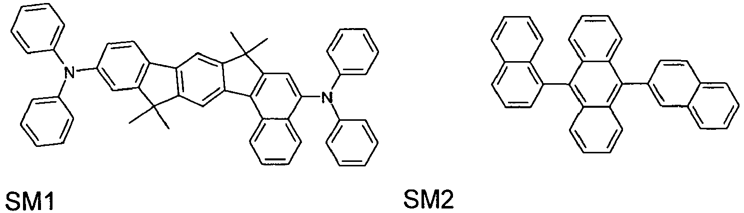

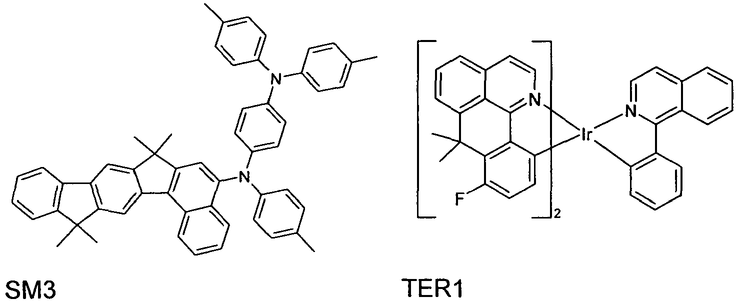

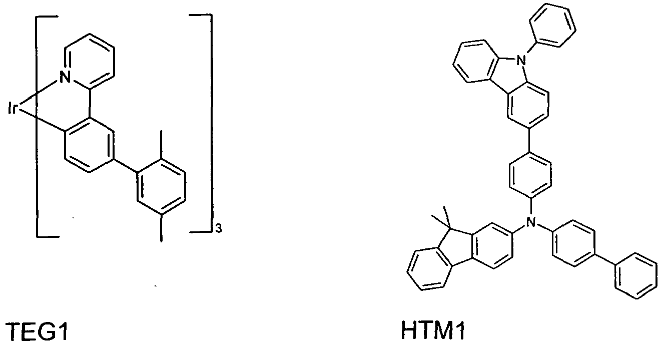

TMM1 is a water-soluble matrix for phosphorescent emitter. The matrix is suitable for triplet green emitter.TMM1 has a triplet level of 2.92 eV (calculated with time-dependent DFT) and the following structure:

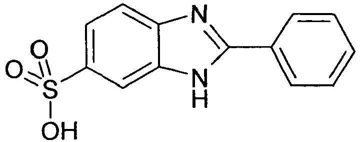

The following perylene diimide (PDI) can be purchased from Sigma-Aldrich, and is used as dye.

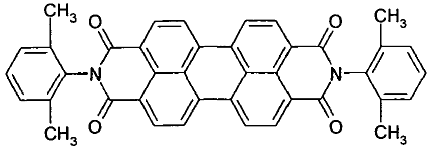

PCBM ([6,6]-Phenyl C61 butyric acid methyl ester) is an electron acceptor, and can be purchased from Sigma-Aldrich.

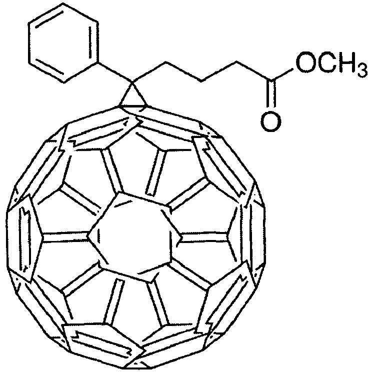

### Example 2 (not forming part of the present invention)

### Preparation of miniemulsions/dispersions

The emulsions, as covered in Table 1, are prepared as exemplary embodiments of the present disclosure. Table 1 shows the compositions of solution 1 and 2 that can be used for the preparation of the emulsions. Composition1 represents the first functional material which is solved in water at the given concentration. Compositions2 represents the second functional material. The weight ratio relates to the total amount of functional material. Composition2 is solved in toluene. In some cases of Table 1 a surfactant is used which is sodium dodecyl sulphate (SDS).

The emulsions are prepared according to the following steps:
a) prepare solution I comprising composition1 in water for the preparation of emulsions 1 to 18 in water according to Table 1. Add SDS as surfactant to solution 1 for emulsions 1 to 3 and 13 to 21 and 13 to 21, whereby the ratio of SDS to water is 0.04 g:10 g;
b) prepare solution II comprising composition2 in toluene for the preparation of emulsions 1 to 18, whereby the ratios and concentrations of the functional materials are given in Table 1;
c) mix solution I with the corresponding solution II (weight ratio of 4:1), and stir by magnetic stirrer at high rate for 1 h;
d) The mixture of step c) is then emulsified using an ultrasonication device (Banson sonifier 450 W, 1/2-inch tip, 90% amplitude);
e) The emulsions of step d) is observed for at least 3 hours in order to validate stability of the emulsion with the bottle cap closed.

**Table 1 - Emulsion with different compositions**

| No. | Solution I | | Solution II | | | Surfactant |
|---|---|---|---|---|---|---|
| | Composition1 | Concentration of Composition1 in water [g/l] | Composition2 Discontinuous Phase in Toluene | Ratio in Composition2 in Weight | Concentration of Composition2 in Toluene [g/l] | |
| 1 | DOCl | 0,5 | SM2 | 100 | 20 | SDS |
| 2 | DOCl | 0.5 | SM2+SM1 | 95:5 | 24 | SDS |
| 3 | Sulforhodamine 101 | 0,5 | SM2+SM1 | 95:5 | 24 | SDS |
| 4 | LEP1 | 10 | SM1 | 100 | 20 | no |
| 5 | LEP1 | 10 | SM3 | 100 | 20 | no |
| 6 | LEP1 | 10 | SM1+SM3 | 50:50 | 20 | no |
| 7 | LEP2 | 10 | SM1+SM3 | 50:50 | 20 | no |
| 8 | TMM1 | 20 | TER1 | 100 | 10 | no |
| 9 | TMM1 | 20 | TEG1 | 100 | 10 | no |
| 10 | TMM1 | 20 | TEG1+TER1 | 50:50 | 20 | no |
| 11 | LEP1 | 10 | PDI + HTM1 | 50:50 | 20 | no |
| 12 | TMM1 | 20 | PDI + PCBM | 50:50 | 20 | no |
| 13 | LEP1 | 10 | SM1 | 100 | 20 | SDS |
| 14 | LEP1 | 10 | SM3 | 100 | 20 | SDS |
| 15 | LEP1 | 10 | SM1+SM3 | 50:50 | 20 | SDS |
| 16 | LEP2 | 10 | SM1+SM3 | 50:50 | 20 | SDS |
| 17 | TMM1 | 20 | TER1 | 100 | 10 | SDS |
| 18 | TMM1 | 20 | TEG1 | 100 | 10 | SDS |
| 19 | TMM1 | 20 | TEG1+TER1 | 50:50 | 20 | SDS |
| 20 | LEP1 | 10 | PDI + HTM1 | 50:50 | 20 | SDS |
| 21 | TMM1 | 20 | PDI + PCBM | 50:50 | 20 | SDS |

In general, highly pure materials are required in electronic and opto-electronic devices. Thus, the concentration of additives, such as surfactants are considered to be as low as possible. Nevertheless, Therefore, two groups of emulsions were prepared; the one group (emulsion 13-21) was with SDS, and the other (emulsion 4-12) without SDS.

Stability of the above mentioned emulsions is investigated by visual inspection. A stable emulsion or dispersion is supposed to show no phase separation and precipitation within a specific period of time. Herein stability was analyzed for a period of 4 h. The emulsions covered in Table 1 are all stable for at least 4 h. Furthermore, the stability of the emulsions comprising a surfactant (i.e. emulsions 1 to 3 and 13 to 21) are investigated for a time period of 24 h. No phase separation or precipitation is observed.

If an emulsion is available, the corresponding dispersions can be prepared employing methods well known to one skilled in the art. Dispersions based on, e.g., emulsions 4 to 12 of Table 1 can be prepared according to the as follows. Toluene of the nanodroplets in the freshly prepared emulsions 4 to 12 is removed by evaporation within 3 h by keeping the bottle open and stirring the emulsion. The dispersions of nanoparticles comprising composition2 dispersed in the solution I comprising compsoition1 in water are obtained.

The diameters of the nanoparticles and its distribution are determined using standard methods known to one skilled in the art via dynamic light scattering (Zeta Nanosizer (Malvern Instruments, UK). The dispersons 4 to 12 have an average diameter ranging from 55 to 80 nm.

### Example 3 (not forming part of the present invention)

### Photoluminescence Spectra

In a particular preferred embodiment of the present disclosure two emitter are present in the discontinuous phase or nanodroplet of the emulsion or dispersion, respectively. In order to take advantage of the Forster energy transfer the absorption spectrum of one emitter has to overlap with the photoluminescence spectrum of the other emitter. Photoluminescence (PL) spectra of the emitter can be measured according to standard techniques well known to a person skilled in the art.

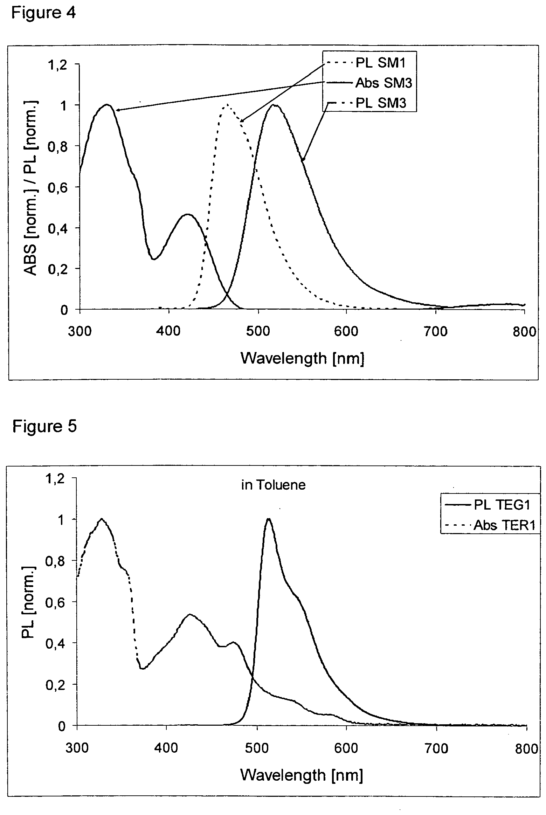

Figure 4 shows the absorption spectrum of SM3 overlapping with the PL spectrum of SM1, which are both singlet emitter. In addition, the PL spectrum of SM3 is shown.

Figure 5 depicts the corresponding spectra for the triplet emitter TEG1 and TER1. The absorption spectrum of TER1 and the PL spectrum of TEG1 overlap.

### Example 4 (not forming part of the present invention)

### OLED4, OLED5, and OLED6

OLED4, OLED5, and OLED6 are prepared employing the dispersions 4, 5, and 6, respectively. The three OLEDs are devices with the general structure as outlined in Figure 3 comprise fluorescent emitter and are prepared according to the following procedure:
a) Depositing 80 nm PEDOT (Baytron P Al 4083) onto ITO coated glass substrate by spin coating, then heating 10 min at 180°C to remove residual water;
b) Depositing 20 nm interlayer by spin coating from toluene solution of IL1 having a concentration of 0.5% wt/l in glovebox;
c) Heating IL1 layer at 180°C for 1 h in glovebox;
d) Adding 20 wt% iso-propanol in the corresponding dispersion, thoroughly stir;
e) Deposition of an EML by spin-coating from the dispersion to a thin film of 60 to -80 nm in thickness;
f) Heating the device at 120°C for 30 minutes in glovebox to remove the residual water;
g) Depositing of a cathode comprising Ba/Al (3 nm/150 nm in thickness) by vacuum thermal evaporation over the emissive layer a cathode;
h) Encapsulating the device by using standard technologies and standard materials known to the person skilled in the art.

### Example 5 (not forming part of the present invention)

### OLED8, OLED9, and OLED10

OLED8, OLED9, and OLED10 are prepared employing the dispersions 8, 9, and 10, respectively. The three OLEDs are devices with the general structure as outlined in Figure 3 comprise phosphorescent emitter and are prepared according to the procedure as outlined in Example 4.

### Example 6 (not forming part of the present invention)

### Characterisation of OLEDs

The devices OLED4 to 6 and OLED8 to 10, as outlined in Example 4 and 5, are investigated with respect to various physical properties employing standard methods well known to the person skilled in the art. The properties recorded are: voltage-current-luminescence (VIL) characteristics, the electroluminescence (EL) spectrum, color coordinates (CIE), efficiency, and driving voltages.

The performance of OLED4 to 6 is summarized in the Table 2 wherein U(1000) is the voltage at 1000 nits (1 nit = 1 cd/m²) and LT DC the lifetime at DC driving mode. The external quantum efficiency is abbreviated as EQE.

**Table 2 - Performance summary of OLED4 to 6 @ 1knits**

| Device | Dispersion used for EML | Eff. [cd/A] | Eff. [lm/W] | U(1000) [V] | CIE @ 1000 cd/m² | EQE @ 1 knits |
|---|---|---|---|---|---|---|
| OLED4 | 4 | 1,90 | 0,9 | 6,3 | 0,15/0,17 | 1.50% |
| OLED5 | 5 | 5,69 | 3,4 | 5,3 | 0,29/0,58 | 1,72% |
| OLED6 | 6 | 10,2 | 6,5 | 4,9 | 0,29/0,58 | 3,10% |

The data in Table 2 show that the double-doping in the fluorescent OLEDs by using dispersions according to the present invention significantly improves the performance of singlet OLED. As compared to OLED5 wherein only SM3 is used as emitter, OLED6 using both SM1 and SM3 gives almost 2 times better efficiency (both in cd/A, Im/W and EQE). A lowered driving voltage is also observed.

**Table 3 - Performance summary of OLED8 to 10**

| Device | Dispersion used for EML | Max Eff. [cd/A] | Uon [V] | U(100) [V] | CIE @ 100 cd/m² | EQE @ Max. Eff. |
|---|---|---|---|---|---|---|
| OLED8 | 8 | 14,00 | 2,6 | 4,2 | 0,37/0,60 | 3,80% |
| OLED9 | 9 | 2,33 | 3,6 | 6,2 | 0,66/0,34 | 2,40% |
| OLED10 | 10 | 4,1 | 2,9 | 4,9 | 0,65/0,35 | 3,86% |

The data in Table 3 show that the double-doping in the phosphorescent OLEDs by using dispersions according to the present invention significantly improves the performance as compared to the OLEDs comprising fluorescent emitter. Uon represents the turn-on voltage. As compared to OLED9 wherein only TER1 is used as phosphorescent emitter, OLED10, employing both TEG1 and TER1 gives much better efficiency (both in Cd/A and EQE) and also a much lower driving voltage.

## Claims

1. Formulation comprising at least one continuous phase and at least one discontinuous phase, wherein at least one of the continuous phases comprises at least one first functional material and wherein at least one of the discontinuous phases comprises at least one second functional material and wherein the first and second functional material(s) is (are) independently from each other selected from hole injection materials (HIM), hole transport materials (HTM), hole blocking materials (HBM), electron injection materials (EIM), electron transport materials (ETM), electron blocking materials (EBM), exciton blocking materials (ExBM), host materials, emitter materials, metal complexes, and dyes
and wherein the formulation comprises at least one solvent and **characterized in that** at least one of the continuous phases comprises at least one host material selected from anthracenes, benzanthracenes, indenofluorenes, fluorenes, spirobifluorenes, phenanthrenes, dehydrophenanthrenes, thiophenes, triazines, imidazole, ketones, carbazoles, triarylamines, and derivatives thereof.

2. Formulation according to claim 1, **characterized in that** at least one of the continuous phases comprises at least one electron transport material selected from imidazoles, pyridines, pyrimidines, pyridazines, pyrazines, oxadiazoles, chinolines, chinoxalines, anthracenes, benzanthracenes, pyrenes, perylenes, benzimidazoles, triazines, ketones, phosphinoxides, phenazines, phenanthrolines, triarylboranes and derivatives thereof.

3. Formulation according to claim 1 or 2, **characterized in that** at least one of the continuous phases comprises at least one hole transport material selected from amines, triarylamines, thiophenes, carbazoles, phthalocyanines, porphyrines and derivatives thereof.

4. Formulation according to one or more of claims 1 to 3, **characterized in that** at least one of the continuous phases comprises at least one emitter material selected from fluorescent emitter materials and phosphorescent emitter materials.

5. Formulation according to one or more of claims 1 to 4, **characterized in that** at least one of the discontinuous phases comprises at least one emitter material.

6. Formulation according to one or more of claims 1 to 5, **characterized in that** at least one of the discontinuous phases comprises at least one emitter material selected from fluorescent emitter materials and phosphorescent emitter materials.

7. Formulation according to one or more of claims 1 to 6, **characterized in that** at least one of the continuous phases comprises at least one host material selected from anthracenes, benzanthracenes, indenofluorenes, fluorenes, spirobifluorenes, phenanthrenes, dehydrophenanthrenes, thiophenes, triazines, imidazole, triaryamines and derivatives thereof, and **in that** at least one of the discontinuous phase comprises at least one fluorescent emitter material.

8. Formulation according to one or more of claims 1 to 7, **characterized in that** at least one of the discontinuous phases comprises two fluorescent emitter materials.

9. Formulation according to one or more of claims 1 to 8, **characterized in that** at least one of the discontinuous phases comprise one fluorescent emitter material.

10. Formulation according to one or more of claims 1 to 9, **characterized in that** at least one of the continuous phases comprises at least one host material selected from ketones, carbazoles, triaryamines, indenofluorenes, fluorenes, spirobifluorenes, phenanthrenes, dehydrophenanthrenes, thiophenes, triazines, imidazoles and derivatives thereof, and **in that** at least one of the discontinuous phase comprises at least one phosphorescent emitter material.

11. Formulation according to one or more of claims 1 to 10, **characterized in that** at least one of the discontinuous phases comprises two phosphorescent emitter materials.

12. Formulation according to one or more of claims 1 to 11, **characterized in that** at least one of the discontinuous phases comprise one phosphorescent emitter material.

13. Formulation according to one or more of claims 1 to 12, **characterized in that** at least one of the discontinuous phases comprises at least one metal complex comprising metals selected from transition metals, rare earth, lanthanide and actinide.

14. Formulation according to one or more of claims 1 to 13, **characterized in that** at least one of the discontinuous phases comprises at least one hole transport material selected from amines, triarylamines, thiophenes, carbazoles, phthalocyanines, porphyrines and derivatives thereof.

15. Formulation according to one or more of claims 1 to 14, **characterized in that** at least one of the discontinuous phases comprises at least one dye selected from perylenes, perylene derivatives, ruthenium dyes, phthalocyanines, phthalocyanine derivatives, azo compounds, perylene diimides, perylene diimide derivatives, porphyrines, porphyrine derivatives, and squaraine compounds.

16. Formulation according to one or more of claims 1 to 15 comprising at least one fullerene or its derivatives, wherein preferably at least one of the discontinuous phases comprises the said fullerene.

17. Method for the preparation of a formulation according to one or more of claims 1 to 16 comprising the following steps:
(a) preparing a first solution comprising said at least one first functional material in at least one first solvent, and optionally comprising at least one surfactant for the formation of the at least one continuous phase;
(b) preparing a second solution comprising said at least one second functional material in at least one second solvent for the formation of the at least one discontinuous phase;
(c) mixing the first solution obtained in step (a) and the second solution obtained in step b) in a specific ratio;
(d) forming a formulation from the mixture obtained in step (c) by a physical method.

18. Method according to claim 17, **characterized in that** the solvent of at least one discontinuous phase of the formulation is removed and if a surfactant is present in the formulation it is, at least in part, removed.

19. Use of the formulation according to one or more of claims 1 to 16 for the preparation of electronic and opto-electronic devices.

20. Use according to claim 19, **characterized in that** the device is selected from organic light emitting diodes (OLEDs), polymer light emitting diodes (PLEDs), fiber OLEDs, organic light emitting electrochemical cells (OLECs), organic field effect transistors (OFETs), thin film transistors (TFTs), organic solar cells (O-SCs), dye-sensitised solar cells (DSSCs), organic laser diodes (O-laser), organic integrated circuits (O-IC), radio frequency identification (RFID) tags, photodetectors, sensors, logic circuits, memory elements, capacitors, charge injection layers, Schottky diodes, planarising layers, antistatic films, conducting substrates or patterns, photoconductors, electrophotographic elements, organic light emitting transistors (OLETs), organic spintronic devices, and organic plasmon emitting devices (OPEDs).

## Patentansprüche

1. Formulierung enthaltend mindestens eine kontinuierliche Phase und mindestens eine diskontinuierliche Phase,
bei der mindestens eine der kontinuierlichen Phasen mindestens ein erstes funktionelles Material enthält und bei der mindestens eine der diskontinuierlichen Phasen mindestens ein zweites funktionelles Material enthält und bei der das/die erste(n) und zweite(n) funktionelle(n) Material(ien) unabhängig voneinander aus Lochinjektionsmaterialien (HIM), Lochtransportmaterialien (HTM), Lochblockiermaterialien (HBM), Elektroneninjektionsmaterialien (EIM), Elektronentransportmaterialien (ETM), Elektronenblockiermaterialien (EBM), Exzitonenblockiermaterialien (EXBM), Host-Materialien, Emittermaterialien, Metallkomplexen und Farbstoffen ausgewählt ist/sind
und bei der die Formulierung mindestens ein Lösungsmittel enthält und **dadurch gekennzeichnet, dass** mindestens eine der kontinuierlichen Phasen mindestens ein aus Anthracenen, Benzanthracenen, Indenofluorenen, Fluorenen, Spirobifluorenen, Phenanthrenen, Dehydrophenanthrenen, Thiophenen, Triazinen, Imidazol, Ketonen, Carbazolen, Triarylaminen und Derivaten davon ausgewähltes Host-Material enthält.

2. Formulierung nach Anspruch 1, **dadurch gekennzeichnet, dass** mindestens eine der kontinuierlichen Phasen mindestens ein aus Imidazolen, Pyridinen, Pyrimidinen, Pyridazinen, Pyrazinen, Oxadiazolen, Chinolinen, Chinoxalinen, Anthracenen, Benzanthracenen, Pyrenen, Perylenen, Benzimidazolen, Triazinen, Ketonen, Phosphinoxiden, Phenazinen, Phenanthrolinen, Triarylboranen und Derivaten davon ausgewähltes Elektronentransportmaterial enthält.

3. Formulierung nach Anspruch 1 oder 2, **dadurch gekennzeichnet, dass** mindestens eine der kontinuierlichen Phasen mindestens ein aus Aminen, Triarylaminen, Thiophenen, Carbazolen, Phthalocyaninen, Porphyrinen und Derivaten davon ausgewähltes Lochtransportmaterial enthält.

4. Formulierung nach einem oder mehreren der Ansprüche 1 bis 3, **dadurch gekennzeichnet, dass** mindestens eine der kontinuierlichen Phasen mindestens ein aus fluoreszierenden Emittermaterialien und phosphoreszierenden Emittermaterialien ausgewähltes Emittermaterial enthält.

5. Formulierung nach einem oder mehreren der Ansprüche 1 bis 4, **dadurch gekennzeichnet, dass** mindestens eine der diskontinuierlichen Phasen mindestens ein Emittermaterial enthält.

6. Formulierung nach einem oder mehreren der Ansprüche 1 bis 5, **dadurch gekennzeichnet, dass** mindestens eine der diskontinuierlichen Phasen mindestens ein aus fluoreszierenden Emittermaterialien und phosphoreszierenden Emittermaterialien ausgewähltes Emittermaterial enthält.

7. Formulierung nach einem oder mehreren der Ansprüche 1 bis 6, **dadurch gekennzeichnet, dass** mindestens eine der kontinuierlichen Phasen mindestens ein aus Anthracenen, Benzanthracenen, Indenofluorenen, Fluorenen, Spirobifluorenen, Phenanthrenen, Dehydrophenanthrenen, Thiophenen, Triazinen, Imidazol, Triarylaminen und Derivaten davon ausgewähltes Host-Material enthält und dass mindestens eine der diskontinuierlichen Phasen mindestens ein fluoreszierendes Emittermaterial enthält.

8. Formulierung nach einem oder mehreren der Ansprüche 1 bis 7, **dadurch gekennzeichnet, dass** mindestens eine der diskontinuierlichen Phasen zwei fluoreszierende Emittermaterialien enthält.

9. Formulierung nach einem oder mehreren der Ansprüche 1 bis 8, **dadurch gekennzeichnet, dass** mindestens eine der diskontinuierlichen Phasen ein fluoreszierendes Emittermaterial enthält.

10. Formulierung nach einem oder mehreren der Ansprüche 1 bis 9, **dadurch gekennzeichnet, dass** mindestens eine der kontinuierlichen Phasen mindestens ein aus Ketonen, Carbazolen, Triarylaminen, Indenofluorenen, Fluorenen, Spirobifluorenen, Phenanthrenen, Dehydrophenanthrenen, Thiophenen, Triazinen, Imidazolen und Derivaten davon ausgewähltes Host-Material enthält und dass mindestens eine der diskontinuierlichen Phasen mindestens ein phosphoreszierendes Emittermaterial enthält.

11. Formulierung nach einem oder mehreren der Ansprüche 1 bis 10, **dadurch gekennzeichnet, dass** mindestens eine der diskontinuierlichen Phasen zwei phosphoreszierende Emittermaterialien enthält.

12. Formulierung nach einem oder mehreren der Ansprüche 1 bis 11, **dadurch gekennzeichnet, dass** mindestens eine der diskontinuierlichen Phasen ein phosphoreszierendes Emittermaterial enthält.

13. Formulierung nach einem oder mehreren der Ansprüche 1 bis 12, **dadurch gekennzeichnet, dass** mindestens eine der diskontinuierlichen Phasen mindestens einen Metallkomplex enthält, der Metalle enthält, die aus Übergangsmetallen, seltener Erde, Lanthanid und Actinid ausgewählt sind.

14. Formulierung nach einem oder mehreren der Ansprüche 1 bis 13, **dadurch gekennzeichnet, dass** mindestens eine der diskontinuierlichen Phasen mindestens ein aus Aminen, Triarylaminen, Thiophenen, Carbazolen, Phthalocyaninen, Porphyrinen und Derivaten davon ausgewähltes Lochtransportmaterial enthält.

15. Formulierung nach einem oder mehreren der Ansprüche 1 bis 14, **dadurch gekennzeichnet, dass** mindestens eine der diskontinuierlichen Phasen mindestens einen aus Perylenen, Perylenderivaten, Rutheniumfarbstoffen, Phthalocyaninen, Phthalocyaninderivaten, Azoverbindungen, Perylendiimiden, Perylendiimidderivaten, Porphyrinen, Porphyrinderivaten und Squarainverbindungen ausgewählten Farbstoff enthält.

16. Formulierung nach einem oder mehreren der Ansprüche 1 bis 15 enthaltend mindestens ein Fulleren oder dessen Derivate, bei der vorzugsweise mindestens eine der diskontinuierlichen Phasen das Fulleren enthält.

17. Verfahren zur Herstellung einer Formulierung nach einem oder mehreren der Ansprüche 1 bis 16, das die folgenden Schritte umfasst:
(a) Herstellen einer ersten Lösung enthaltend das mindestens eine erste funktionelle Material in mindestens einem ersten Lösungsmittel und gegebenenfalls enthaltend mindestens ein Tensid zur Bildung der mindestens einen kontinuierlichen Phase;
(b) Herstellen einer zweiten Lösung enthaltend das mindestens eine zweite funktionelle Material in mindestens einem zweiten Lösungsmittel zur Bildung der mindestens einen diskontinuierlichen Phase;
(c) Mischen der in Schritt (a) erhaltenen ersten Lösung und der in Schritt (b) erhaltenen zweiten Lösung in einem spezifischen Verhältnis;
(d) Bilden einer Formulierung aus der in Schritt (c) erhaltenen Mischung durch ein physikalisches Verfahren.

18. Method nach Anspruch 17, **dadurch gekennzeichnet, dass** das Lösungsmittel der mindestens einen diskontinuierlichen Phase der Formulierung entfernt wird und, wenn in der Formulierung ein Tensid vorhanden ist, dieses, zumindest teilweise, entfernt wird.

19. Verwendung der Formulierung nach einem oder mehreren der Ansprüche 1 bis 16 für die Herstellung von elektronischen und optoelektronischen Vorrichtungen.

20. Verwendung nach Anspruch 19, **dadurch gekennzeichnet, dass** die Vorrichtung aus organischen Leuchtdioden (organic light emitting diodes - OLEDs), Polymer-Leuchtdioden (polymer light emitting diodes - PLEDs), Faser-OLEDs, organischen lichtemittierenden elektrochemischen Zellen (organic light emitting electrochemical cells - OLECs), organischen Feldeffekttransistoren (organic field effect transistors - OFETs), Dünnschichttransistoren (thin film transistors - TFTs), organischen Solarzellen (organic solar cells - O-SCs), farbstoffsensibilisierten Solarzellen (dye-sensitised solar cells - DSSCs), organischen Laserdioden (organic laser diodes - O-laser), organischen integrierten Schaltungen (organic integrated circuits - O-IC), RFID-Tags (RFID - radio frequency identification), Photodetektoren, Sensoren, logischen Schaltungen, Speicherelementen, Kondensatoren, Ladungsinjektionsschichten, Schottky-Dioden, Planarisierungsschichten, Antistatikfolien, leitenden Substraten oder Strukturen, Photoleitern, elektrophotographischen Elementen, organischen lichtemittierenden Transistoren (organic light emitting transistors - OLETs), organischen Spintronic-Vorrichtungen und organischen Plasmon-emittierenden Vorrichtungen (organic plasmon emitting devices - OPEDs) ausgewählt ist.

## Revendications

1. Formulation comprenant au moins une phase continue et au moins une phase discontinue, dans laquelle au moins l'une des phases continues comprend au moins un premier matériau fonctionnel et dans laquelle au moins l'une des phases discontinues comprend au moins un second matériau fonctionnel et dans laquelle les premier(s) et second(s) matériaux fonctionnels sont sélectionnés de manière indépendante l'un de l'autre ou les uns des autres parmi les matériaux d'injection de trous (HIM), les matériaux de transport de trous (HTM), les matériaux de blocage de trous (HBM), les matériaux d'injection d'électrons (EIM), les matériaux de transport d'électrons (ETM), les matériaux de blocage d'électrons (EBM), les matériaux de blocage d'excitons (ExBM), les matériaux hôtes, les matériaux d'émetteur, les complexes métalliques et les colorants
et dans laquelle la formulation comprend au moins un solvant et **caractérisée en ce qu'**au moins l'une des phases continues comprend au moins un matériau hôte qui est sélectionné parmi les anthracènes, les benzanthracènes, les indénofluorènes, les fluorènes, les spirobifluorènes, les phénanthrènes, les déshydrophénanthrènes, les thiophènes, les triazines, les imidazoles, les cétones, les carbazoles, les triarylamines et les dérivés de ceux-ci.

2. Formulation selon la revendication 1, **caractérisée en ce qu'**au moins l'une des phases continues comprend au moins un matériau de transport d'électrons qui est sélectionné parmi les imidazoles, les pyridines, les pyrimidines, les pyridazines, les pyrazines, les oxadiazoles, les chinolines, les chinoxalines, les anthracènes, les benzanthracènes, les pyrènes, les perylènes, les benzimidazoles, les triazines, les cétones, les phosphinoxydes, les phénazines, les phénanthrolines, les triarylboranes et les dérivés de ceux-ci.

3. Formulation selon la revendication 1 ou 2, **caractérisée en ce qu'**au moins l'une des phases continues comprend au moins un matériau de transport de trous qui est sélectionné parmi les amines, les triarylamines, les thiophènes, les carbazoles, les phtalocyanines, les porphyrines et les dérivés de ceux-ci.

4. Formulation selon une ou plusieurs des revendications 1 à 3, **caractérisée en ce qu'**au moins l'une des phases continues comprend au moins un matériau d'émetteur qui est sélectionné parmi les matériaux d'émetteur fluorescents et les matériaux d'émetteur phosphorescents.

5. Formulation selon une ou plusieurs des revendications 1 à 4, **caractérisée en ce qu'**au moins l'une des phases discontinues comprend au moins un matériau d'émetteur.

6. Formulation selon une ou plusieurs des revendications 1 à 5, **caractérisée en ce qu'**au moins l'une des phases discontinues comprend au moins un matériau d'émetteur qui est sélectionné parmi les matériaux d'émetteur fluorescents et les matériaux d'émetteur phosphorescents.

7. Formulation selon une ou plusieurs des revendications 1 à 6, **caractérisée en ce qu'**au moins l'une des phases continues comprend au moins un matériau hôte qui est sélectionné parmi les anthracènes, les benzanthracènes, les indénofluorènes, les fluorènes, les spirobifluorènes, les phénanthrènes, les déshydrophénanthrènes, les thiophènes, les triazines, les imidazoles, les triarylamines et les dérivés de ceux-ci, et **en ce qu'**au moins l'une des phases discontinues comprend au moins un matériau d'émetteur fluorescent.

8. Formulation selon une ou plusieurs des revendications 1 à 7, **caractérisée en ce qu'**au moins l'une des phases discontinues comprend deux matériaux d'émetteur fluorescents.

9. Formulation selon une ou plusieurs des revendications 1 à 8, **caractérisée en ce qu'**au moins l'une des phases discontinues comprend un seul matériau d'émetteur fluorescent.

10. Formulation selon une ou plusieurs des revendications 1 à 9, **caractérisée en ce qu'**au moins l'une des phases continues comprend au moins un matériau hôte qui est sélectionné parmi les cétones, les carbazoles, les triarylamines, les indénofluorènes, les fluorènes, les spirobifluorènes, les phénanthrènes, les déshydrophénanthrènes, les thiophènes, les triazines, les imidazoles et les dérivés de ceux-ci, et **en ce qu'**au moins l'une des phases discontinues comprend au moins un matériau d'émetteur phosphorescent.

11. Formulation selon une ou plusieurs des revendications 1 à 10, **caractérisée en ce qu'**au moins l'une des phases discontinues comprend deux matériaux d'émetteur phosphorescents.

12. Formulation selon une ou plusieurs des revendications 1 à 11, **caractérisée en ce qu'**au moins l'une des phases discontinues comprend un seul matériau d'émetteur phosphorescent.

13. Formulation selon une ou plusieurs des revendications 1 à 12, **caractérisée en ce qu'**au moins l'une des phases discontinues comprend au moins un complexe métallique qui comprend des métaux qui sont sélectionnés parmi les métaux de transition, les terres rares, les lanthanides et les actinides.

14. Formulation selon une ou plusieurs des revendications 1 à 13, **caractérisée en ce qu'**au moins l'une des phases discontinues comprend au moins un matériau de transport de trous qui est sélectionné parmi les amines, les triarylamines, les thiophènes, les carbazoles, les phtalocyanines, les porphyrines et les dérivés de ceux-ci.

15. Formulation selon une ou plusieurs des revendications 1 à 14, **caractérisée en ce qu'**au moins l'une des phases discontinues comprend au moins un colorant qui est sélectionné parmi les perylènes, les dérivés de perylène, les colorants ruthénium, les phtalocyanines, les dérivés de phtalocyanine, les composés azo, les diimides de perylène, les dérivés de diimide de perylène, les porphyrines, les dérivés de porphyrine et les composés de squaraine.

16. Formulation selon une ou plusieurs des revendications 1 à 15, comprenant au moins un fullerène ou ses dérivés, dans laquelle, de préférence, au moins l'une des phases discontinues comprend ledit fullerène.

17. Procédé pour la préparation d'une formulation selon une ou plusieurs des revendications 1 à 16, comprenant les étapes qui suivent :
(a) la préparation d'une première solution qui comprend ledit au moins un premier matériau fonctionnel dans au moins un premier solvant, et en option qui comprend au moins un surfactant pour la formation de l'au moins une phase continue ;
(b) la préparation d'une seconde solution qui comprend ledit au moins un second matériau fonctionnel dans au moins un second solvant pour la formation de l'au moins une phase discontinue ;
(c) le mélange de la première solution qui est obtenue au niveau de l'étape (a) et de la seconde solution qui est obtenue au niveau de l'étape (b) selon un rapport spécifique ; et
(d) la formation d'une formulation à partir du mélange qui est obtenu au niveau de l'étape (c) au moyen d'un procédé physique.

18. Procédé selon la revendication 17, **caractérisé en ce que** le solvant d'au moins une phase discontinue de la formulation est enlevé et si un surfactant est présent dans la formulation, il est, au moins en partie, enlevé.

19. Utilisation de la formulation selon une ou plusieurs des revendications 1 à 16 pour la préparation de dispositifs électroniques et optoélectroniques.

20. Utilisation selon la revendication 19, **caractérisée en ce que** le dispositif est sélectionné parmi les diodes à émission de lumière organiques (OLED), les diodes à émission de lumière polymère (PLED), les OLED à fibre(s), les cellules électrochimiques à émission de lumière organiques (OLEC), les transistors à effet de champ organiques (OFET), les transistors à film mince (TFT), les cellules solaires organiques (O-SC), les cellules solaires sensibilisées par colorant(s) (DSSC), les diodes laser organiques (O-laser), les circuits intégrés organiques (O-IC), les étiquettes d'identification radiofréquence (RFID), les photodétecteurs, les capteurs, les circuits logiques, les éléments de mémoire, les condensateurs, les couches d'injection de charges, les diodes Schottky, les couches de planarisation, les films antistatiques, les substrats ou motifs de conduction, les photoconducteurs, les éléments électrophotographiques, les transistors à émission de lumière organiques (OLET), les dispositifs spintroniques organiques et les dispositifs à émission de plasmons organiques (OPED).
